Europäisches Patentamt

European Patent Office

Office européen des brevets

(19)

(11) **EP 1 120 916 A1**

(12) **EUROPEAN PATENT APPLICATION**
published in accordance with Art. 158(3) EPC

(43) Date of publication:
**01.08.2001 Bulletin 2001/31**

(51) Int Cl.⁷: **H03M 13/00**

(21) Application number: **99943397.2**

(86) International application number:
**PCT/JP99/05086**

(22) Date of filing: **17.09.1999**

(87) International publication number:
**WO 00/18018 (30.03.2000 Gazette 2000/13)**

(84) Designated Contracting States:
**AT BE CH CY DE DK ES FI FR GB GR IE IT LI LU MC NL PT SE**

(30) Priority: **17.09.1998 JP 26316198**

(71) Applicant: **Asahi Kasei Kabushiki Kaisha Osaka-shi, Osaka 530-8205 (JP)**

(72) Inventor: **AOKI, Hiroshi
Yokohama-shi, Kanagawa 240-0044 (JP)**

(74) Representative: **Selting, Günther et al
Patentanwälte
von Kreisler, Selting, Werner
Deichmannhaus
Postfach 10 22 41
50462 Köln (DE)**

(54) **BRANCH METRIC OPERATION DEVICE AND VITERBI DECODING DEVICE**

(57)     A replacing portion (210) replaces a sampled value from an A/D converter (10) with one of expected values ($B_0$, $B_1$, $B_2$, $B_3$, $B_4$) in accordance with a predetermined rule. A branch metric table (230) stores a branch metric which has been predetermined on the basis of the sampled value replaced by the replacing portion (210) and the expected values and correlated with the sampled value. A branch metric determining portion (220) derives the branch metric corresponding to the sampled value to be replaced in the replacing portion 210 from the branch metric table (230). Thus, complicated operation is eliminated to reduce the amount of operation and to reduce the size of the device scale.

# FIG. 1

EXPECTED VALUE ($B_0$,$B_1$,$B_2$,$B_3$,$B_4$)

200

BRANCH METRIC OPERATION DEVICE

10
A/D CONVERTER

ANALOG WAVEFORM

210
REPLACING PORTION

220
BRANCH METRIC DETERMINING PORTION

230
BRANCH METRIC TABLE

30
ACS COMPUTING DEVICE

40
PATH MEMORY

50
DECODER

DIGITAL DATA

**Description**

TECHNICAL FIELD

The present invention relates to a branch metric operation device and a Viterbi decoding device to be used for decoding in Viterbi algorithm on the basis of a plurality kinds of expected values and sample values.

BACKGROUND ART

Upon reproduction of a digital signal from a digital signal storage medium, such as DVD, MO or the like, due to degradation of high frequency characteristics of a signal processing system or a reproducing optical system or other cause, a reproduction signal does not becomes an ideal rectangular wave and becomes a rounded waveform causing a difficult in discriminating the digital signal between "1" and "0". In order to accurately reproduce the digital signal from such waveform, decoding using a maximum likelihood estimation method, such as Viterbi algorithm or the like has been widely performed.

While Viterbi algorithm has been technically disclosed in various publications, such as "Error bounds for convolutional codes and an sympototically optimum decoding algorithm", IEEE, Trans. Inform. Theory, Vol. IT-13, Apr. 1967. The summary of the Viterbi algorithm is described to easy to understand the background of the present invention.

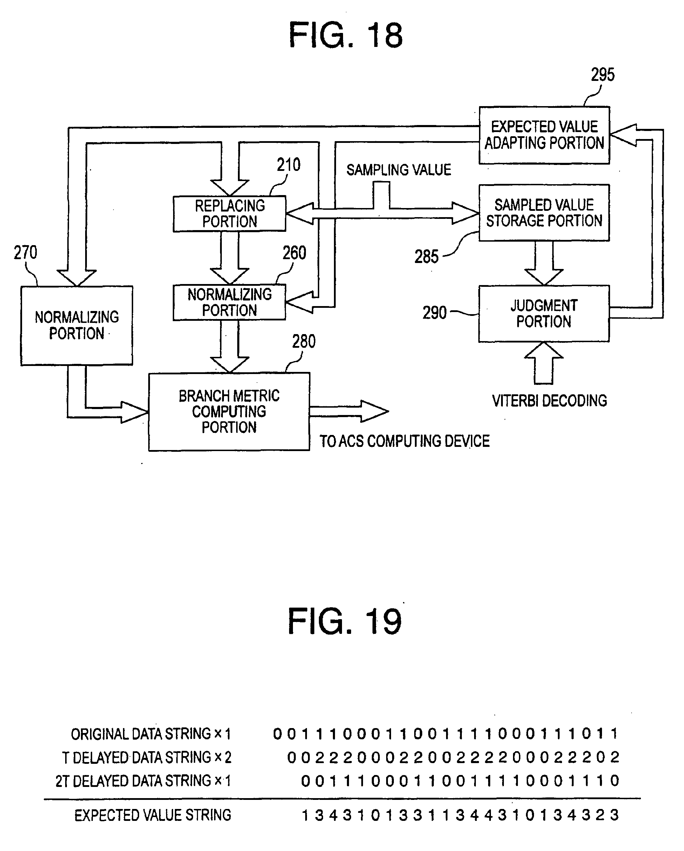

Here, when an input data string is as shown in Fig. 19, an expected value of an analog waveform from a pick-up of an optical disk or the like, which is ideal equivalent in a PR (1, 2, 1) system, as sampled at an ideal timing, is shown in Fig. 19. In Fig. 19, a first line is an original data string, a second line is a data string of double value of data delayed for a sampling period T from the original data, a third line is a data string delayed double of the sampling period T of the original data, and a fourth line is an expected value string deriving by summing each data in vertical direction from the first line to the third line.

As set forth, the value sampled in ideal condition by the PR (1, 2, 1) system becomes an expected value of any one of 0, 1, 2, 3 and 4. However, due to noise, error in sampling timing, actual sampled period, the actually sampled value becomes a value shifted from the expected value. One of methods for predicting and reproducing an original input data from the shifted sampled value is Viterbi decoding (Viterbi decode). This Viterbi decoding has been widely used for decoding of convolutional code in addition to decoding of PR system set forth above.

In the foregoing PR (1, 2,1) system, a relationship between the original data (input) and the expected value (output) shown in Fig. 19 can be expressed by a state transition diagram of four state ($S_{00}$, $S_{01}$, $S_{10}$, $S_{11}$) in fine values (five kinds of expected values of 0, 1, 2, 3, 4,5). In this drawing, "x/y" expresses "output/input".

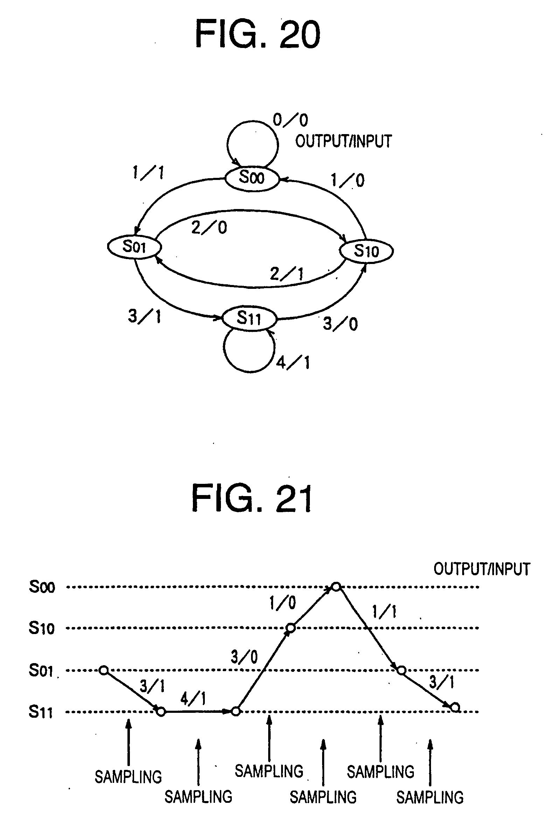

As shown by state transition chart, for example, when 1 is input in the state of $S_{01}$, 3 is output and state is transited to state $S_{11}$. In $S_{11}$, when 1 is further input, 4 is output and the state is transited to the state $S_{11}$. Furthermore, when 0 is further input in the state $S_{11}$, 3 is output and the state is transited to $S_{10}$. When 0 is further input in $S_{10}$, 1 is output and the state transits to state $S_{00}$. When 1 is input in $S_{00}$, 1 is output and the state is transited to $S_{01}$. When 1 is input further input in $S_{01}$, 3 is output and the state transit to $S_{11}$. When the current state and the state depending upon the input are transited, a manner of state transition extended in time axis direction is referred to as a trellis diagram (see Fig. 21). One of the methods to decode the input data from the output waveform thereof is Viterbi decoding.

As set forth above, noise is superimposed on the actual digital sampling waveform (= reproduction waveform), it does not match with the expected value (from $B_0$ to $B_4$) to possibly cause error if input data is fixed per sample. However, in case of Viterbi decoding, the input data is fixed based on maximum likelihood state transition by deriving probability possibility to be taken after state transition per sampling.

For example, in order to be in the state $S_{11}$ at a certain period, there are only two possibilities "the state before is $S_{01}$, the input is 1 and the output is 3, or the state before is $S_{11}$, the input is 1 and the output is 4". At this time, it is assumed that the sampled value is actually "3.3", as square (branch metric) of a difference (Euclidean distance) of the expected value and the sampled value, two kinds, i.e. bm3 $(3.3 - 3)^2 = 0.09$, bm4 = $(3.3 - 4)^2 = 0.49$, are obtained. These values correspond to square of the error.

Then, assuming that a path metrics expressing probability in the preceding states are $Pm_{01} = 1.0$ and $Pm_{11} = 2.0$, "$Pm_{01} + bm3 = 1.09$, $Pm_{11} + bm4 = 2.49$", square of error in the path to be "$S_{01} \rightarrow S_{11}$" is smaller to survive as more probable state transition to establish new path metric as $Pm_{01} = 1.09$.

For respective of other states $S_{00}$, $_s01$, $S_{10}$, similar operation is performed to sequentially select paths having smaller accumulated total of square of error to take the path having the least error as surviving path. From the state transition where the surviving path is established, the input data is decoded for outputting.

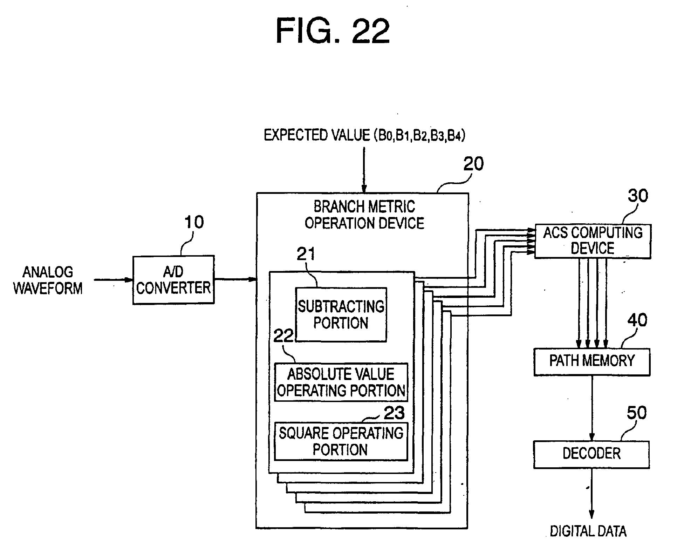

Next, discussion will be given for construction and operation of a Viterbi decoding device including the conventional branch metric operation device with reference to Figs. 22 to 26.

As shown in Fig. 22, the conventional Viterbi decoding device has anA/D converter 10 digital sampling an analog waveform, a branch metric operation device 20, an ACS (Added Compare Selection) computing device 30, a path memory 40 and a decoder 50.

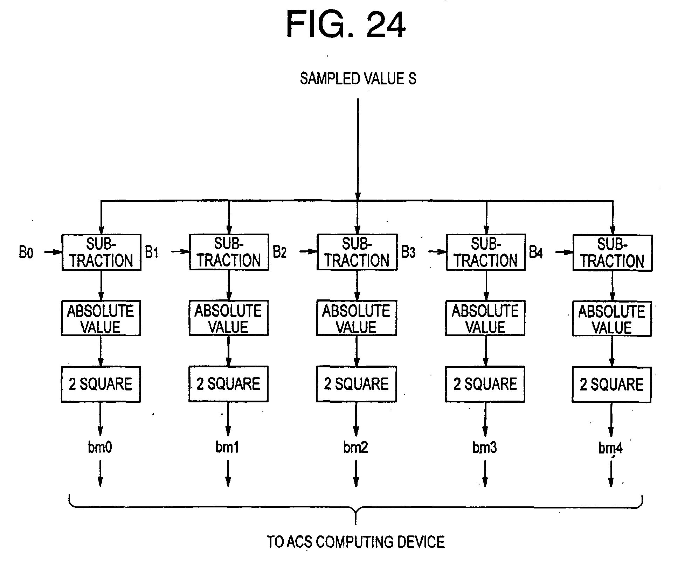

The branch metric operation device 20 is constructed with sets each includes a subtracting portion 21, an absolute value operation portion 22 and a square operation portion 23, in number corresponding to number of kinds of the expected value. As shown in Fig. 24, the operation is that is performed in such a manner that subtraction between the sampled value S in the A/D converter portion 10 and the expected value ($B_0$, $B_1$, $B_2$, $B_3$, $B_4$) is performed by the subtracting portion 21, an absolute value of the result of subtraction is derived by the absolute value operation portion 22, and then, a square of the absolute value is derived by the square operation portion 23 for deriving five kinds of branch metrics bm0, bm1, bm2, bm3 and bm4 to be fed to the ACS computing device 30.

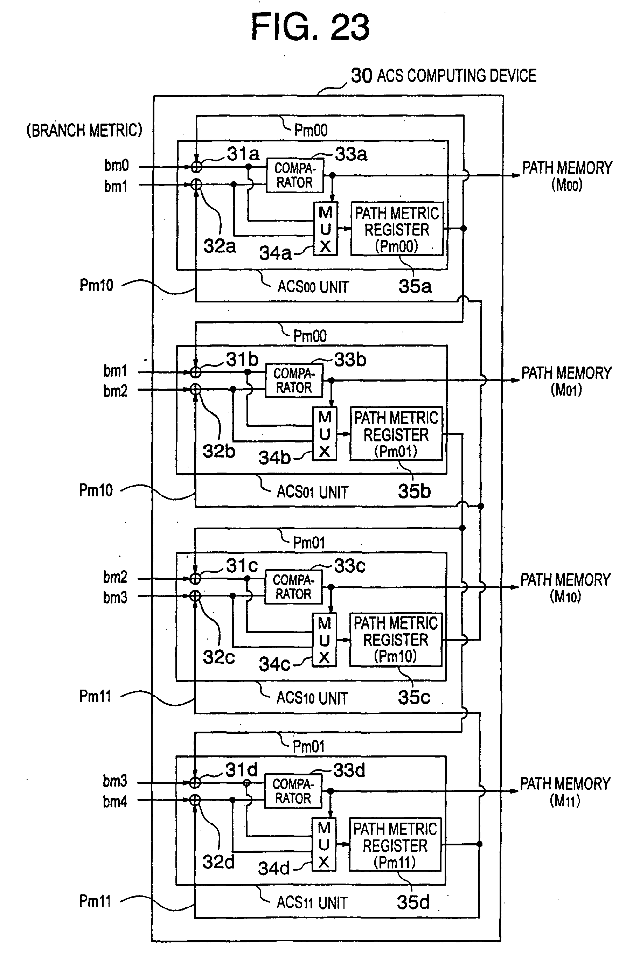

As shown in Fig. 23, the ACS computing device 30 is constructed with $ACS_{00}$ unit, $ACS_{01}$ unit, $ACS_{10}$ unit and $ACS_{11}$ unit respectively provided for respective states of $S_{00}$, $S_{01}$, $S_{10}$ and $S_{11}$.

The inside of each unit is the same construction and includes adders 31 and 32, a comparator 33, a multiplexer (MUX) 34 and a path metric register 35. Amongst, one $ACS_{00}$ unit derives path metrics transiting to the state $S_{00}$, in which the adder 31a adds the branch metric bm0 to the current path metric $Pm_{00}$ (corresponding transition from the state $S_{00}$ to the state $S_{00}$), and the adder 32a adds the branch metric bm1 to the current path metric $Pm_{10}$ (corresponding to transition from the state $S_{10}$ to the state $S_{00}$), and the comparator 33a makes judgment of large and small relationship therebetween. In response to the result of judgment, the multiplexer 34 newly holds smaller one of path metrics as path metric corresponding to more probable state transition in the path metric register 35a. At this time, the $ACS_{00}$ unit feeds information ($M_{00}$) of the probable path to the path memory 40. The path memory stores this.

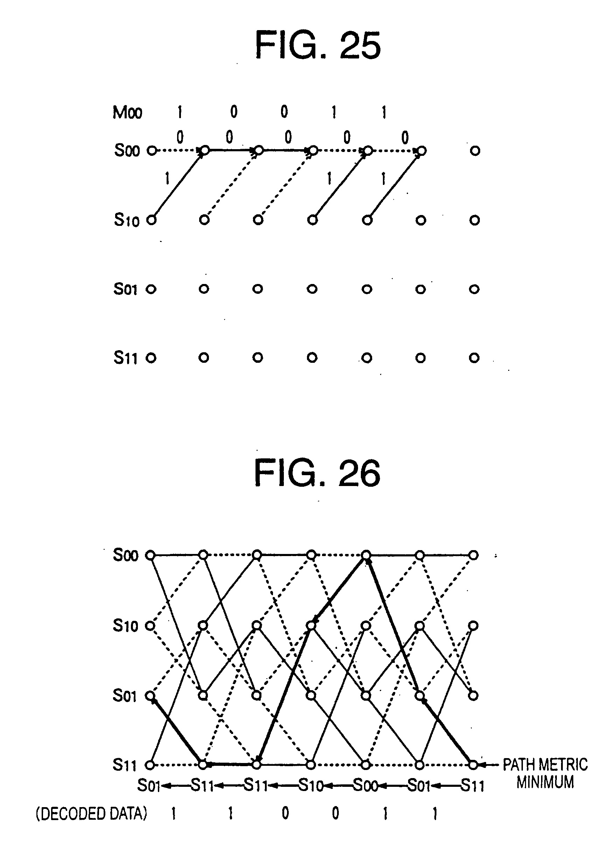

As shown in Fig. 25, for example this information is generated by the digital signal which becomes "0" when the path from the state $S_{00}$ to the state $S_{00}$ is selected, and "1" when the path from the state $S_{10}$ to the state $S_{00}$ is selected. The $ACS_{00}$ unit is constructed to feed this information ($M_{00}$) to the path memory 40.

Similarly, the $ACS_{01}$ unit, the $ACS_{10}$ unit and the $ACS_{11}$ unit respectively derive path metrics transiting to the states $S_{01}$, $S_{10}$ and $S_{11}$ to hold in the path metric register, and in conjunction therewith, the information $M_{00}$, $M_{01}$, $M_{10}$ and $M_{11}$ of the selected path are transmitted to the path memory 40.

The path memory 40 stores path information $M_{00}$, $M_{01}$, $M_{10}$ and $M_{11}$ sequentially per each state $S_{00}$, $S_{01}$, $S_{10}$ and $S_{11}$. Then, the decoder 50 makes reference to the path metric register to detect the path metric which is the smallest at a certain timing (smallest path metric) to sequentially derive selected path string with reference to the storage content of the path memory 40 to take this as surviving path, and in conjunction therewith, to take the digital signal corresponding to respective selected path consisting the surviving path as decoded data, or to perform Viterbi decoding utilizing that fact, even when retracing is initiated from the state transition not the smallest path metric, it converges to the same path as the state transition of the smallest path metric if retraced for sufficiently long period.

In Fig. 26, there is shown an example where the path metric to the state $S_{11}$ becomes minimum path metric, and shows manner of decoding of the digital data of "110011" by retracing the state transition along the surviving path shown by thick line.

As can be seen from the foregoing discussion, in the conventional branch metric operation device, since branch metric is derived by deriving the absolute value of the subtraction result between the sampled value S and the expected value and by deriving square of the derived absolute value, a problem is encountered in large operation amount to make scale of the device large for performing operation. On the other hand, since the bit width of the obtained branch metric is large, operation bit width in the ACS computing device in the later stage becomes large. As a result, problem is encountered in large scale of the device and the speed cannot be improved.

Further particular discussion will be given for the problems in the prior art.

Here, since it may facilitate understanding to consider that the output value of the A/D converter 10 of Fig. 22, namely the sampled value is integer, the foregoing content will be discussed in different description. Here, the foregoing expected values 0, 1, 2, 3 and 4 are arranged symmetrically in positive and negative, a new expected value is assumed to be a value subtracting 2 from the foregoing expected value and then multiplied by 8. As a result, new expected values are -16, -8, 0, +8 and +16.

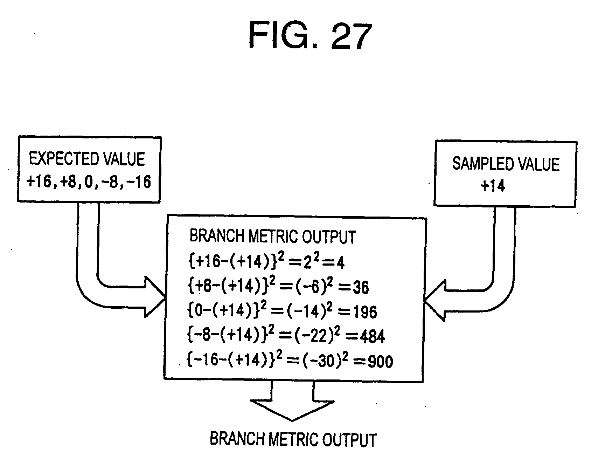

Under the new expected values, when the samples value is +14, for example, the branch metric operations, in the conventional device are five kinds as follow as shown in Fig. 27:

$$\{+16 - (+14)\}^2 = 4$$

$$\{+8 - (+14)\}^2 = (-6)^2 = 36$$

$$\{0 - (+14)\}^2 = (-14)^2 = 196$$

$$\{-8 - (+14)\}^2 = (-22)^2 = 484$$

$$\{-16 - (+14)\}^2 = (-30)^2 = 900$$

Accordingly, in the conventional branch metric operation device, since square of errors are calculated between the sampled value and five kinds of expected value, five sets of subtracters, the absolute value calculator and multipliers are required, and values to be handled is large. If the samples value has 6 bit width (-32 - +31), for example, the subtracters of 7 bit width (-63 - +63) is required for calculation of the error of the expected value, and 12 bit width becomes necessary for handling square of the 6 bits (+63 - 0) of the absolute value.

On the other hand, in the device having the sets in number corresponding to number of kinds of the expected value, with consisting each set with the subtracter 21, the absolute value operation portion 22 and the square operation portion 23, a problem is encountered in that the scale of the device is significantly increased according to increase of number of kinds of the expected values.

The present invention has been worked out for solving the problems set forth above in the prior art. Therefore, an object of the present invention is to provide a branch metric operation device which can be down sized the scale of the device by reducing an operation amount by making complicate operation unnecessary, and in conjunction therewith, to provide a higher speed ACS operation device with down-sizing of the scale of the device by reducing operation amount even in the ACS operation device in the later stage.

On the other hand, another object of the present invention is to provide a Viterbi decoding device including the branch metric operation device.

DISCLOSURE OF THE INVENTION

The present invention provides a branch metric operation device for operation of branch metric to be used for decoding in a Viterbi algorithm on the basis of a sampled value of an input data and a preliminarily set plurality of expected values, comprising replacing means for replacing the sampled value with one of the expected values according to a predetermined rule, storage means for storing branch metrics preliminarily derived on the basis of the replaced sampled value and the plurality of expected values with correspondence to the replaced sampled value; and branch metric determining means for deriving branch metrics corresponding to the replaced sampled value from the storage means.

The present invention provides a branch metric operation device for operation of branch metric to be used for decoding in a Viterbi algorithm on the basis of a sampled value of an input data and a preliminarily set plurality of expected values, comprising replacing means for replacing the sampled value with one of the expected values according to a predetermined rule, normalizing means for normalizing the replaced sampled value and the expected values, and branch metric calculating means for deriving branch metrics from the normalized sampled value and the normalized plurality of expected values.

In the embodiment of the branch metric operation device according to the present invention, when the sampled value is present within the numerical value width determined for each expected value, the predetermined rule is to replace the sampled value with the expected value for a relevant numerical value width, and the replacing means is means for replacing the sampled value with the expected value for the relevant numerical value width when the sampled value is present within the numerical value width determined with respect to each expected value.

The present invention provides branch metric operation device for operation of branch metric to be used for decoding in a viterbi algorithm on the basis of a sampled value of an input data and a preliminarily set plurality of expected values, comprising replacing means for determining numerical value width for each expected value and arranging blind regions between determined numerical value widths, when the sampled value is present in a certain numerical value width, replacing the sampled value with the expected value for the relevant numerical value width, and when the sampled value is present in certain blind region, replacing the sampled value with a value determined for the relevant blind region, storage means for storing branch metrics preliminarily derived on the basis of the replaced sampled value and the plurality of expected values with correspondence to the replaced sampled value, and branch metric determining means for deriving branch metrics corresponding to the replaced sampled value from the storage means.

The present invention provides a branch metric operation device for operation of branch metric to be used for decoding in a Viterbi algorithm on the basis of a sampled value of an input data and a preliminarily set plurality of expected values, comprising replacing means for determining numerical value width for each expected value and arranging blind regions between determined numerical value widths, when the sampled value is present in a certain numerical value width, replacing the sampled value with the expected value for the relevant numerical value width, and when the sampled value is present in certain blind region, replacing the sampled value with a value determined for the relevant blind region, normalizing means for normalizing the replaced sampled value and the expected values, and branch metric calculating means for deriving branch metrics from the normalized sampled value and the normalized plurality of expected values.

As an embodiment, the branch metric operation device according to the invention further comprises storage means for storing the sampled value, judgment means for making judgment which of the expected values corresponds to the sampled value stored in the storage means from a result of Viterbi decoding on the basis of result of operation of the branch metric operation means, and adapting means for adapting the expected values on the basis of the result of judgment, the replacing means is adapted to perform replacement on the basis of the adapted expected value, and the normalizing means performs normalization on the basis of the adapted expected values.

The present invention provides a Viterbi decoding device comprising a branch metric operation device any one those set forth above, an ACS computing device calculating a path metric corresponding to each state, a path memory storing information showing a probably path trace per each state, and decoding means performing data decoding determining a surviving path with reference to information stored in the path memory.

BRIEF DESCRIPTION OF THE DRAWINGS

Fig. 1 is a block diagram showing a construction of an embodiment of a Viterbi decoding device including a branch metric operation device 200, according to the present invention;

Fig. 2 is an explanatory illustration of an example of a replacement rule in the case of a PR (1, 2, 1) system;

Fig. 3 is a flowchart for explaining a replacement process performed by a replacing portion 210;

Fig. 4 is a flowchart for explaining a process to be performed by a branch metric determining portion 220;

Fig. 5 is an explanatory illustration for explaining an effect of the embodiment of the present invention;

Fig. 6 is a block diagram showing the branch metric device of Fig. 1 in rewritten form;

Fig. 7 is an explanatory illustration of a replacement rule;

Fig. 8 is a flowchart for explaining a replacement process to be performed by a replacing portion 210;

Fig. 9 is a flowchart for explaining a normalizing process of a normalizing portion;

Fig. 10 is a flowchart for explaining a process for deriving a branch metric by a branch metric calculating portion;

Fig. 11 is an explanatory illustration of another replacement rule in another embodiment;

Fig. 12 is a flowchart for explaining another embodiment of process to be performed by replacing portion;

Fig. 13 is a flowchart for explaining another embodiment of process to be performed by the branch metric determining portion 220;

Fig. 14 is an explanatory illustration of a replacement rule in another embodiment;

Fig. 15 is a flowchart for explaining another replacement process to be performed in the replacing portion 210;

Fig. 16 is a flowchart for explaining another normalizing process of the normalizing portion;

Fig. 17 is a flowchart for explaining another process for deriving a branch metric by the branch metric calculating portion;

Fig, 18 is a block diagram showing a construction of another embodiment of the branch metric device of the present invention;

Fig. 19 is an illustration showing one example of an input data string and an expected value string;

Fig. 20 is an explanatory illustration (state transition diagram) for explaining a Viterbi algorithm;

Fig. 21 is an explanatory illustration (trellis diagram) for explaining the Viterbi algorithm;

Fig. 22 is a block diagram showing a construction of the conventional Viterbi decoding device including the branch metric operation device;

Fig. 23 is a block diagram showing a construction of an ACS computing device 30;

Fig. 24 is a flowchart for explaining the conventional process for deriving branch metric;

Fig. 25 is an explanatory diagrammatic illustration of path selection information stored in a path memory 40;

Fig. 26 is an explanatory diagrammatic illustration of operation of a decoder 50; and

Fig. 27 is an illustration showing a particular example of a branch metric calculation in the conventional device.

BEST MODE FOR IMPLEMENTING THE INVENTION

An embodiment of the present invention will be discussed hereinafter with reference to the drawings.

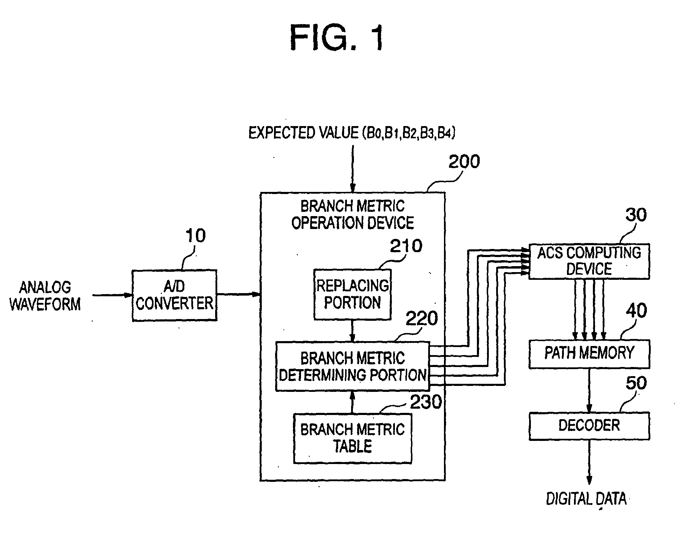

Fig. 1 is a block diagram showing a construction of an embodiment of a Viterbi decoding device including a branch metric operation device 200, according to the present invention. It should be noted that, in Fig. 1, components the same as the components of the conventional Viterbi decoding device shown in Fig. 22 will be identified by the same reference numerals.

As shown in Fig. 1, the Viterbi decoding device includes the A/D converter 10 for digital sampling of an analog waveform transmitted from a head amplifier or the like of a not shown reproduction device, a branch metric operation device 200, an ACS (Add Compare Select) computing device 30, a path memory 40 and a decoder 50.

Construction and operation of major components of the Viterbi decoding device will be discussed hereinafter.

The branchmetric operation device 200 includes a replacing portion 210 replacing a sampled value with any one of expected values ($B_0$, $B_1$, $B_2$, $B_3$, $B_4$) according to a predetermined rule, a branch metric table 230 storing branch metrics which branch metrics bm0 - bm4 which will be discussed later, are preliminarily derived on the basis of the sampled value replaced by the replacing portion 210 and the foregoing plurality of expected values, with correspondence to sampled value to be replaced, and a branch metric determining portion 220 deriving the branch metric corresponding to the sampled value to be replaced in the replacing portion 210 from the branch metric table 230.

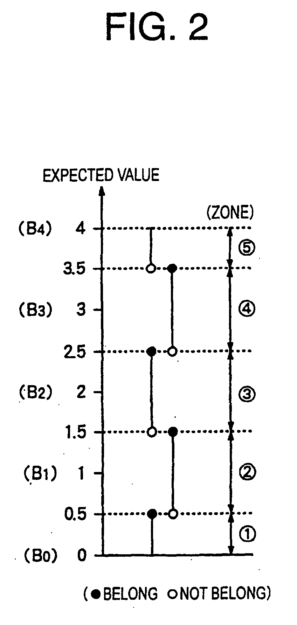

When the sampled value falling within a value range determined with respect to each expected value, is present, the replacing portion 210 replaces with the sampled value with the expected value related to the relevant value range. As an example, a particular method concerning a replacement process by making judgment, in which zone of ①~ ⑤ of Fig. 2, will be shown. The expected value shown in Fig. 2 is 0, 1, 2, 3, 4 which values are normalized value of the expected values $B_0$, $B_1$, $B_2$, $B_3$, $B_4$ to have the simplest integer ratio, such as 0, 1, 2, 3, 4.

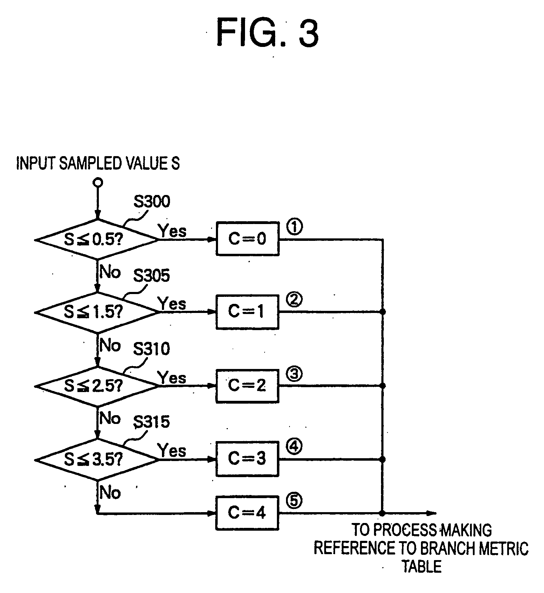

Fig. 3 shows a replacement process. At first, judgment is made whether the sampled value S is less than or equal to 0.5 or not. If the sampled value S is less than or equal to 0.5 (Yes), the sampled value S is judged as belonging in the zone ① the replacement value C = 0 (this value is 0 as normalized value of the expected value $B_0$ corresponding to the zone ①) is set. Otherwise (No), a process is advanced to next step (step S300). Then, judgment is made whether the sampled value S is less than or equal to 1.5 or not. If the sampled value S is less than or equal to 1.5 (Yes), the sampled value S is judged as belonging in the zone ②, the replacement value C = 1 is set. Otherwise (No), a process is advanced to next step (step S305). Then, judgment is made whether the sampled value S is less than or equal to 2.5 or not. If the sampled value S is less than or equal to 2.5 (Yes), the sampled value S is judged as belonging in the zone ③, the replacement value C = 2 is set. Otherwise (No), a process is advanced to next step (step S310). Then, judgment is made whether the sampled value S is less than or equal to 3.5 or not. If the sampled value S is less than or equal to 3.5 (Yes), the sampled value S is judged as belonging in the zone ④, the replacement value C = 3 is set. Otherwise (No), the sampled value S is judged as belonging in the zone ⑤, the replacement value C = 4 (step S315) is set. As set forth above, the sampled value is replaced with any one of the expected values.

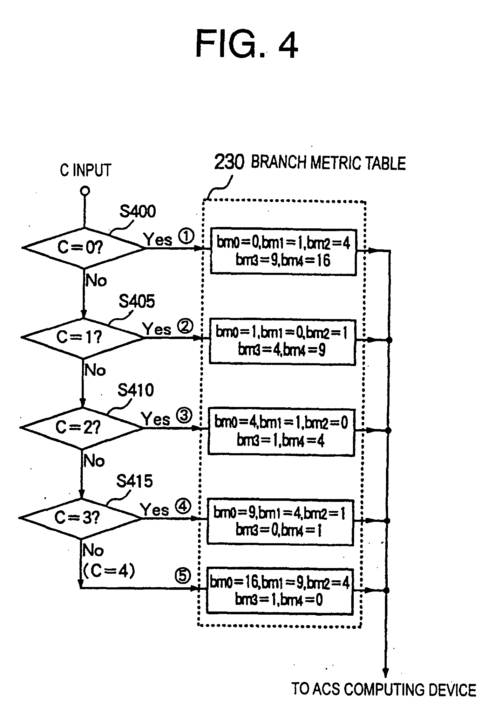

As shown in Fig. 4, the branch metric determining portion 220 makes judgment whether the replacement value C is 0 or not. If the replacement value C is 0 (Yes), branch metric corresponding to C = 0 is derived from the branch metric table 230 (bm0 = 0, bm1 = 1, bm2 = 4, bm3 = 9, bm4 = 16) to output the same. Otherwise (No), the process is advanced to the next step (step S400). Then, judgment is made whether the replacement value C is 1 or not. If the replacement value C is 1 (Yes), branch metric corresponding to C = 1 is derived from the branch metric table 230 (bm0 = 1, bm1 = 0, bm2 = 1, bm3 = 4, bm4 = 9) to output the same. Otherwise (No), the process is advanced to the next step (step S405). Then, judgment is made whether the replacement value C is 2 or not. If the replacement value C is 2 (Yes), branch metric corresponding to C = 2 is derived from the branch metric table 230 (bm0= 4, bm1 = 1, bm2 = 0, bm3 = 1, bm4 = 4) to output the same. Otherwise (No), the process is advanced to the next step (step S410). Then, judgment is made whether the replacement value C is 3 or not. If the replacement value C is 3 (Yes), branch metric corresponding to C = 3 is derived from the branch metric table 230 (bm0 = 9, bm1 = 4, bm2 = 1, bm3 = 0, bm4 = 1) to output the same. Otherwise (No), branch metric corresponding to C = 4 is derived from the branch metric table 230 (bm0 = 16, bm1 = 9, bm2 = 4, bm3 = 1, bm4 = 0) to output the same (step S415). As set forth, branch metrics preliminarily stored in the branch metric table 230 with respect to the replacement value are obtained. The output branch metrics are fed to the ACS computing device 30.

It should be noted that the values of the branch metrics bm0 - bm4 preliminarily stored in the branch metric table 230 are the values derived by operation of "bm0 = $(C - B_0)^2$, bm1 = $(C - B_1)^2$, bm2 = $(C - B_2)^2$, bm3 = $(C - B_3)^2$, bm4 = $(C - B_4)^2$", in the shown embodiment. Here, as $B_0$, $B_1$, $B_2$, $B_3$, $B_4$, the foregoing normalized values 0, 1, 2, 3, 4 are used.

The ACS computing device 30 is the same as that set forth above, and, as shown in Fig. 23, is constructed with the $ACS_{00}$ unit, the $ACS_{01}$ unit, the $ACS_{10}$ unit and the $ACS_{11}$ unit provided corresponding to respective states of $S_{00}$, $S_{01}$, $S_{10}$, $S_{11}$.

The inside of each unit is similar construction and includes adders 31, 32, the comparator 33, the multiplexer (MUX) 34 and the path metric register 35. For example, one of the $ACS_{00}$ unit is for operation of path metric transiting to the state $S_{00}$. The adder 31a adds the branch metric bm0 to the current path metric $Pm_{00}$ (corresponding to transition from the state $S_{00}$ to the state $S_{00}$) and the adder 32a adds the branch metric bm1 to the current path metric $Pm_{10}$ (corresponding to transition from the state $S_{10}$ to the state $S_{00}$). The comparator 33a makes judgment of large and small relationship of the both results. In response to the result of judgment, the multiplexer 34 newly holds smaller path metric as path metric corresponding to more probable state transition in the path metric register 35. At this time. the $ACS_{00}$ unit feeds information of probably path to the path memory 40. Then, the path memory 40 stores the same.

This information is generated by the digital signal which becomes "0" when path from the state $S_{00}$ to the state $S_{00}$ is selected and "1" when path from the state $S_{10}$ to the state $S_{00}$ is selected. The $ACS_{00}$ unit is constructed to feed this information ($M_{00}$) to the path memory 40.

Similarly, respective of the $ACS_{01}$ unit, the $ACS_{10}$ unit and the $ACS_{11}$ unit calculate path metrics transiting to the states $S_{01}$, $S_{10}$ and $S_{11}$ to hold in the path metric register, and in conjunction therewith, to transmit the information $M_{01}$, $M_{10}$, $M_{11}$ of the selected path to the path memory 40.

The path memory 40 is constructed to sequentially store the path information $M_{00}$, $M_{01}$, $M_{10}$, $M_{11}$ per respective states $S_{00}$, $S_{01}$, $S_{10}$, $S_{11}$.

The decoder 50 makes reference to the path metric register to detect the path metric which is the smallest at a certain timing (smallest path metric) to sequentially derive selected path string with reference to the storage content of the path memory 40 to take this as surviving path, and in conjunction therewith, to take the digital signal corresponding to respective selected path consisting the surviving path as decoded data, to perform Viterbi decoding. In Fig. 26, there is shown an example where the path metric to the state $S_{11}$ becomes minimum path metric, and shows manner of decoding of the digital data of "110011" by retracing the state transition along the surviving path shown by thick line.

Accordingly, in the overall operation of the Viterbi decoding device is at first, when the analog waveform is applied, the A/D converter 10 performs digital sampling. The digital sampled value S is fed to the branch metric operation device 200. Next, the replacing portion 210 performs replacement of the sampled value S according to a predetermined rule. The branch metric determining portion 220 obtains the branch metric corresponding the replaced value from the branch metric table 230 to sequentially feed to the ACS computing device 30. In the ACS computing device 30, path metrics with respect to respective states $S_{00}$, $S_{01}$, $S_{10}$, $S_{11}$ are calculated and held, and in conjunction therewith, the information $M_{00}$, $M_{01}$, $M_{10}$, $M_{11}$ of the selected path with respect to respective state are transmitted to the path memory 40. Then, the decoder 50 determines the surviving path with reference to the smallest path metric at certain timing and the information of the selected path stored in the path memory 40, and performed decoding of the digital data by retracing the state transition along the surviving path.

Accordingly, in the shown embodiment, the replacing portion 210 replaces the sampled value with one of the expected values according to the predetermined rule. Since the branch metric determining portion 220 derives the branch metric with reference to the storage content of the branch metric table 230, complicate operation becomes unnecessary to reduce operation amount to realize the branch metric operation device 200 or the Viterbi decoding device incorporating the same which can be down-sized.

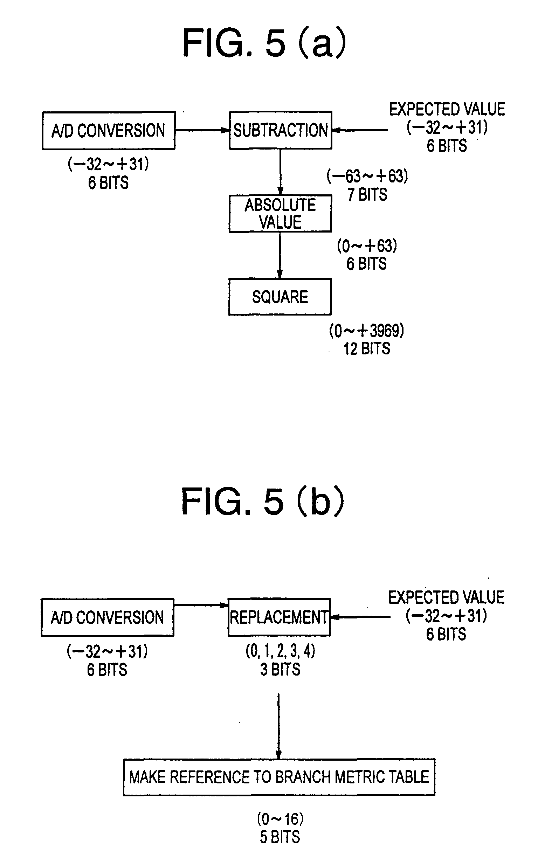

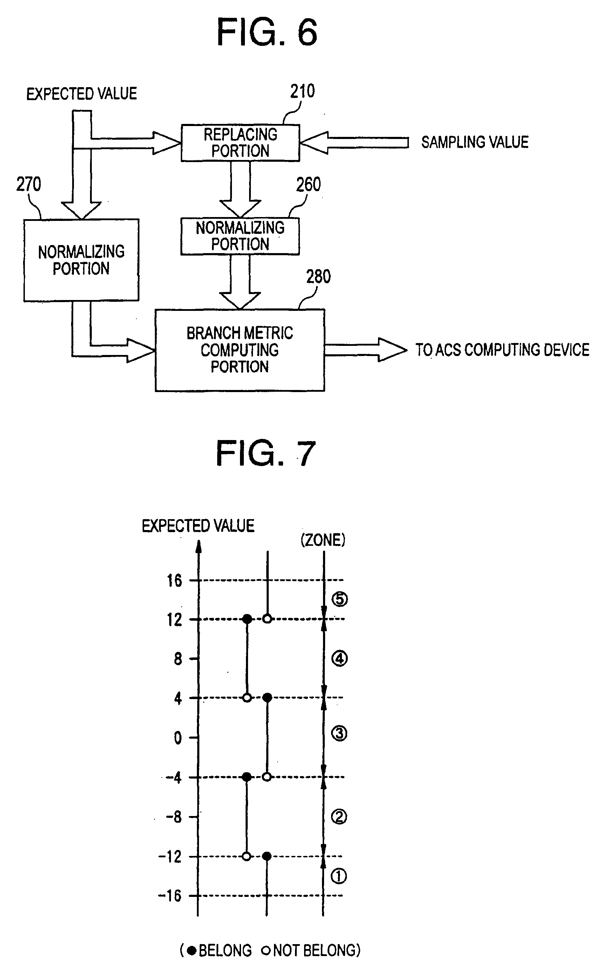

Fig. 5 is an explanatory illustration showing an effect of the embodiment with taking the signal of five values of the PR (1, 2, 1) characteristics. As shown in Fig. 5(a), in the prior art, when 6 bits are used for A/D conversion, 7 bits are used for subtraction with the expected value. In order to derive the absolute value thereof, 6 bits are used and to derive square, operation in 12 bits is required. In contrast to this, according to the shown embodiment illustrated in Fig. 5(b), 6 bits operation for A/D conversion, 3 bits operation for replacement and 5 bits operation for outputting the branch metric with reference to the branch metric table are merely required. Thus, it can be appreciated that the operation amount can be reduced. Furthermore, as the bit number of the branch metric becomes smaller even in the ACS in the next stage, operation amount in the ACS can be reduced.

In the discussion given heretofore, the branch metric determining portion 220 of the branch metric operation device 200 derives branch metric on the basis of the expected value to be replaced by the replacing portion 210. However, upon deriving the branch metric, functions of replacement and normalization are incorporated. Rewritten form of the branch metric operation device 200 of Fig. 1 making replacement and normalization definitely illustrated is the branch metric operation device shown in Fig. 6.

As shown in Fig. 6, this branch metric operation device has the replacing portion 210 replacing the sampled value with one of preliminarily set plurality of expected values, a normalizing portion 260 normalizing the expected value replaced in the replacing portion 210, a normalizing portion 270 normalizing a plurality of expected values respectively, and a branch metric computing portion 280 deriving branch metric on the basis of the sampled value normalized by the normalizing portion 260 and the expected values normalized by the normalizing portion 270. The branch metric thus derives is output to the ACS computing device 30.

Here, considering the actual output value of the A/D converter 10 of Fig. 1, namely the sampled value, as integer will facilitate understanding. Therefore, the foregoing context will be discussed in different manner of description. Here, it is assumed that the expected values 0, 1, 2, 3, 4 shown in Fig. 2 are arranged in symmetrically in positive value and negative value, and new expected value is derived as a value derived by subtracted 2 from the foregoing expected values and then multiplied for eight times. As the results, the new expected values become -16, -8, 0, +8, +16.

When the sampled value falls within a predetermined numerical range with respect to respective expected values, the replacing portion 210 replaces the sampled value with the expected value with respect to the numerical value. as one example, as shown in Fig. 7, the replacement process is performed with making judgment in which zone of the zones ①~ ⑤ the expected value is present.

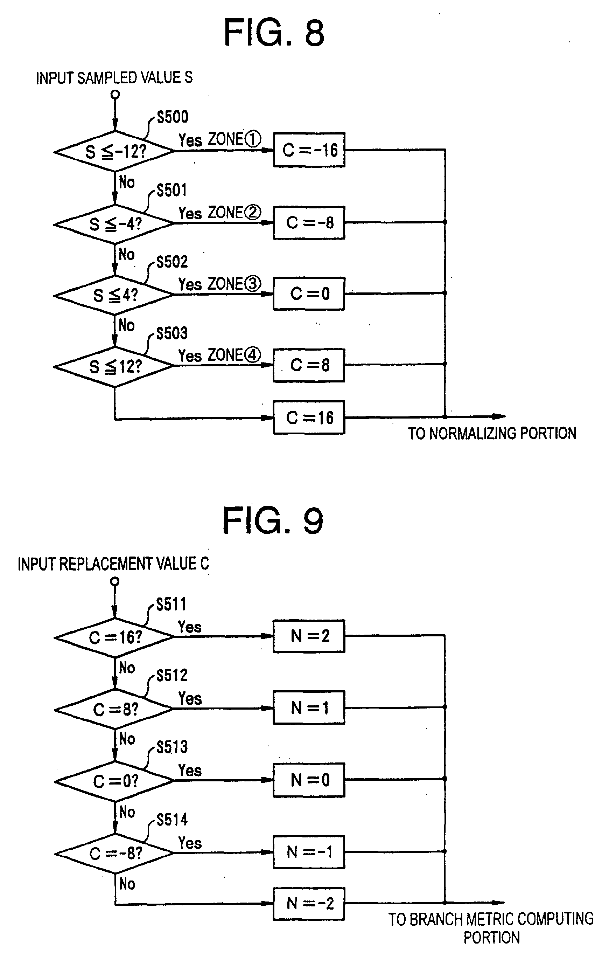

Fig. 8 shows the replacement process. At first, at step S500, the sampled value is checked whether it is smaller than or equal to -12 or not. If the sampled value is less than or equal to -12 (Yes), judgment is made that the sampled value is belonging in the zone ① to set a re-writing value (replacement value) C = -16. Otherwise (No), the process is advanced to the next step S501. At next step S501, the sampled value is checked whether it is smaller than or equal to -4 or not. If the sampled value is less than or equal to -4 (Yes), judgment is made that the sampled value is belonging in the zone ② to set a re-writing value C = -8. Otherwise (No), the process is advanced to the next step S502.

At next step S501, the sampled value is checked whether it is smaller than or equal to 4 or not.

If the sampled value is less than or equal to 4 (Yes), judgment is made that the sampled value is belonging in the zone ③ to set a re-writing value C = 0. Otherwise (No), the process is advanced to the next step S503. At next step S503, the sampled value is checked whether it is smaller than or equal to 12 or not. If the sampled value is less than or equal to 12 (Yes), judgment is made that the sampled value is belonging in the zone ④ to set a re-writing value (replacement value) C = 8. Otherwise (No), judgment is made that the sampled value is belonging in the zone ⑤ to set a re-writing value (replacement value) C = 16.

As set forth above, the samples value is replaced with one of the expected value. For example, when the sampled value is +14, it is replaced with +16.

Next, such replaced value by the replacing portion 210 and the five expected values -16. -8. 0, 8, 16 are respectively normalized to establish the simplest integer ratio by the normalizing portions 260 and 270. The normalizing process of the normalizing portion 260 will be discussed with reference to Fig. 9.

At first, at step S511, the replacement value C is checked whether it is 16 or not. If the replacement value C is 16, it is normalized to +2. Other wise, the process is advanced to step S512. Then, the replacement value C is checked whether it is 8 or not. If the replacement value C is 8, it is normalized to +1. Other wise, the process is advanced to step S513. At step S513, the replacement value C is checked whether it is 0 or not. If the replacement value C is 0, it is normalized to 0. Other wise, the process is advanced to step S514. Then, the replacement value C is checked whether it is -8 or not. If the replacement value C is -8, it is normalized to -1. Other wise, the replacement value C is normalized to -2. By such normalizing process, the values after normalization becomes 2, 1, 0, -1, -2.

Here. in the normalizing portion 270, the expected values are normalized by the similar process. On the other hand, the normalizing portion 260 and the normalizing portion 270 are provided independently in Fig. 6. However, they may be provided as single normalizing portion to perform normalizing process for both of the replacement value and the expected values.

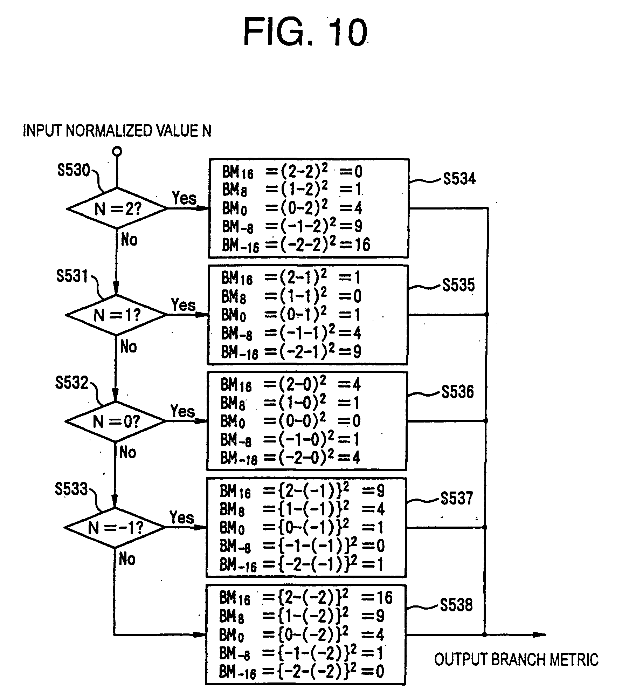

Next, on the basis of both normalizing values of the normalizing portion 270 and the normalizing portion 260, the branch metric computing portion 280 derives the branch metric through the process shown in Fig. 10. Discussion will be given therefor.

At first, at step S530, the normalized value N derived by the normalizing portion 260 is checked whether it is 2 or not. If the normalized value N is 2, the process is advanced to step S534 to respectively calculate five branch metrics $BM_{16}$, $BM_8$, $BM_0$, $BM_{-8}$, $BM_{-16}$ as the normalized value N being 2. Namely, respective calculation of $BM_{16} = (2 - 2)^2 = 0$, $BM_8 = (1 - 2)^2 = 1$, $BM_0 = (0 - 2)^2 = 4$, $BM_{-8} = (-1 -2)^2 = 9$, $BM_{-16} = (-2 -2)^2 = 16$.

Here, $BM_{16}$ is branch metric for the expected value 16, $BM_8$ is branch metric for the expected value 8, $BM_0$ is branch metric for the expected value 0, $BM_{-8}$ is branch metric for the expected value -8 and $BM_{-16}$ is branch metric for the expected value -16.

Next, at step S530, when the normalized value N is not 2, next, the process is advanced to step S531, the normalized value N is checked whether it is 1 or not. If the normalized value N is 1, the process is advanced to step S535 to respectively calculate five branch metrics $BM_{16}$, $BM_8$, $BM_0$, $BM_{-8}$, $BM_{-16}$ as the normalized value N being 1. Namely, respective calculation of $BM_{16} = (2 - 1)^2 = 1$, $BM_8 = (1 - 1)^2 = 0$, $BM_0 = (0 - 1)^2 = 1$, $BM_{-8} = (-1 -1)^2 = 4$, $BM_{-16} = (-2 -1)^2 = 9$.

Next, at step S531, when the normalized value N is not 1, next, the process is advanced to step S532, the normalized value N is checked whether it is 0 or not. If the normalized value N is 0, the process is advanced to step S536 to respectively calculate five branch metrics $BM_{16}$, $BM_8$, $BM_0$, $BM_{-8}$, $BM_{-16}$ as the normalized value N being 0. Namely, respective calculation of $BM_{16} = (2 - 0)^2 = 4$, $BM_8 = (1 - 0)^2 = 1$, $BM_0 = (0 - 0)^2 = 0$, $BM_{-8} = (-1 -0)^2 = 1$, $BM_{-16} = (-2 -0)^2 = 4$.

Next, at step S532, when the normalized value N is not 0, next, the process is advanced to step S533, the normalized value N is checked whether it is -1 or not. If the normalized value N is -1, the process is advanced to step S537 to respectively calculate five branch metrics $BM_{16}$, $BM_8$, $BM_0$, $BM_{-8}$, $BM_{-16}$ as the normalized value N being -1. Namely, respective calculation of $BM_{16} = (2 - (-1))^2 = 9$, $BM_8 = (1 - (-1))^2 = 4$, $BM_0 = (0 - (-1))^2 = 1$, $BM_{-8} = (-1 -(-1))^2 = 0$, $BM_{-16} = (-2 - (-1))^2 = 1$.

Next, at step S533, when the normalized value N in the normalizing portion 260 is not -1, the normalized value is regarded as -2. Then, the process is advanced to step S538 to respectively calculate five branch metrics $BM_{16}$, $BM_8$, $BM_0$, $BM_{-8}$, $BM_{-16}$ as the normalized value N being -2. Namely, respective calculation of $BM_{16} = (2 - (-2))^2 = 16$, $BM_8 = (1 - (-2))^2 = 9$, $BM_0 = (0 - (-2))^2 = 4$, $BM_{-8} = (-1 - (-2))^2 = 1$, $BM_{-16} = (-2 - (-2))^2 = 0$.

As set forth above, in the branch metric computing portion 280, branch metric is calculated from the normalized value N. Therefore, the bit width as in the conventional system is unnecessary. In addition, the values of the branch metric are also only 0, $1^2 = 1$, $2^2 = 4$, $3^2 = 9$, $4^2 = 16$. Therefore, the branch metric computing portion 280 can make the scale of the circuit small using a combined logic in place of multiplier.

On the other hand, in the shown example, when the maximum value of the branch metric is rounded to be 15 instead of 16, necessary bit width for expressing the branch metric can be reduced from 5 bits (10000 in binary number) to 4 bits (1111 in binary number). Also, while calculation corresponding to square of the error is performed as branch metric, it is also possible to use an absolute value of the error. In such case, the circuit can be further simplified. However, concerning quality of the decoded signal, it is possible to be degraded in comparison with the case of the square of error is used.

It should be noted that, in the shown example, as shown in Fig. 10, the branch metrics are respectively calculated depending upon the normalized value, it is also possible to preliminarily derive and store the branch metrics depending upon the normalized values in a table (memory) to derive the branch metric by making reference to the table depending upon actual normalized value.

Next, discussion will be given for another embodiment of the present invention. This embodiment is characterized in that the replacement process of the sampled value is performed by providing a blind region at the intermediate range of the expected value.

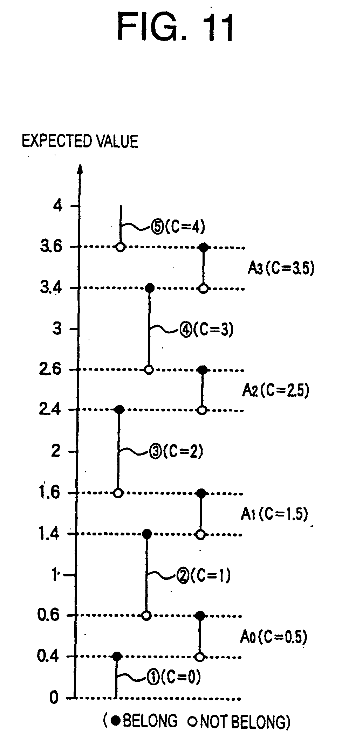

Fig. 11 is an illustration showing a replacement rule of the sampled value. Zones $A_0$, $A_1$, $A_2$, $A_3$ where the samples values are "$0.4 < S \leqq 0.6$, $1.4 < S \leqq 1.6$, $2.4 < S \leqq 2.6$, $3.4 < S \leqq 3.6$" are taken as blind zones and other regions ① to ⑤ are provided value widths corresponding to respective expected values.

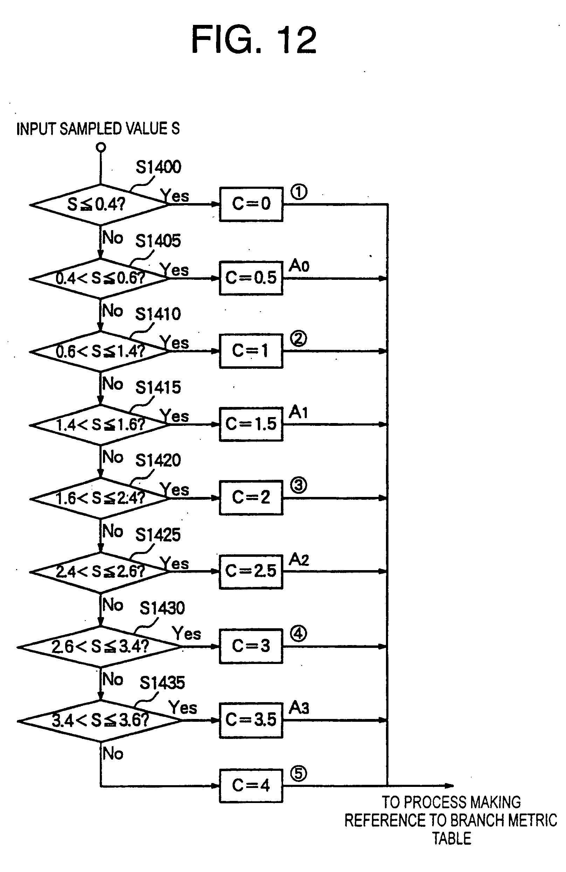

Fig. 12 shows the replacement process to be performed by the replacing portion 210 similarly to Fig. 4. At first, check is performed whether the sampled value S is smaller than or equal to 0.4 or not. If the sampled value S is smaller than or equal to 0.4, judgment is made that the sampled value S belongs in the zone ① to set the replacement value C = 0. Otherwise, the process is advanced to next step (step S1400). Then, check is performed whether the sampled value S is greater than 0.4 and smaller than or equal to 0.6 or not. If the sampled value falls within the region (Yes), judgment is made that the sampled value S falls within the blind region $A_0$ to set the replacement value C = 0.5. Otherwise (No), the process is advanced to the next step (step S1405). Then, check is performed whether the sampled value S is greater than 0.6 and smaller than or equal to 1.4 or not. If the sampled value falls within the region (Yes), judgment is made that the sampled value S falls within the zone ② to set the replacement value C = 1. Otherwise (No), the process is advanced to the next step (step S1410). Then, check is performed whether the sampled value S is greater than 1.4 and smaller than or equal to 1.6 or not. If the sampled value falls within the region (Yes), judgment is made that the sampled value S falls within the blind region $A_1$ to set the replacement value C = 1.5. Otherwise (No), the process is advanced to the next step (step S1415).

Also, check is performed whether the sampled value S is greater than 1.6 and smaller than or equal to 2.4 or not. If the sampled value falls within the region (Yes), judgment is made that the sampled value S falls within the zone ③ to set the replacement value C = 2. Otherwise (No), the process is advanced to the next step (step S1420). Then, check is performed whether the sampled value S is greater than 2.4 and smaller than or equal to 2.6 or not. If the sampled value falls within the region (Yes), judgment is made that the sampled value S falls within the blind region $A_2$ to set the replacement value C = 2.5. Otherwise (No), the process is advanced to the next step (step S1425). Then, check is performed whether the sampled value S is greater than 2.6 and smaller than or equal to 3.4 or not. If the sampled value falls within the region (Yes), judgment is made that the sampled value S falls within the zone ④ to set the replacement value C = 3. Otherwise (No), the process is advanced to the next step (step S1430). Then, check is performed whether the sampled value S is greater than 3.4 and smaller than or equal to 3.6 or not. If the sampled value falls within the region (Yes), judgment is made that the sampled value S falls within the blind region $A_3$ to set the replacement value C = 3.5. Otherwise (No), judgment is made that the sampled value S falls within the zone ⑤ to set the replacement value C = 4 (step S1435). As set forth above, the sampled value is replaced with one of the expected value or the values for the blind regions.

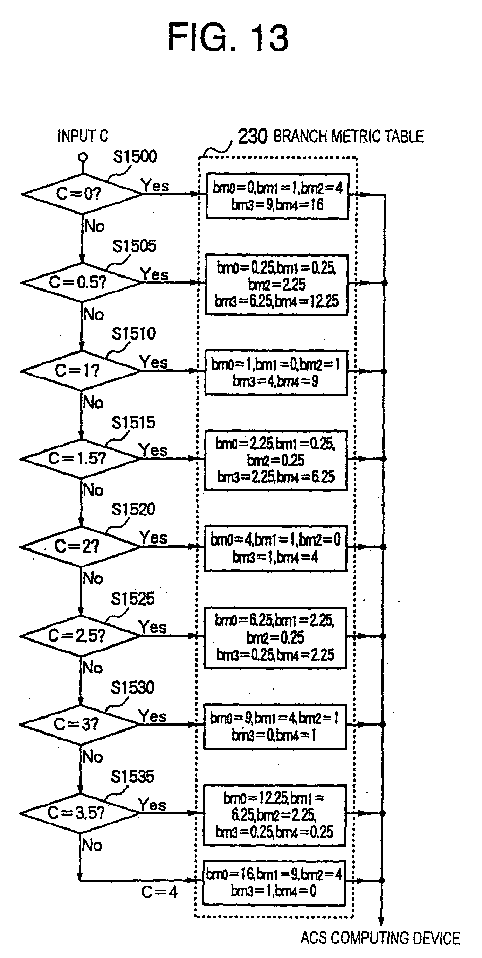

Next, the branch metric determining portion 220 performs the operation shown in Fig. 13. At first at step S1500, the replacement value C is 0 or not. If the replacement value C is 0 (Yes) the branch metric corresponding to the replacement value C =0 is derived from the branch metric table 230 (bm0 = 0, bm1 = 1, bm2 = 4, bm3 = 9, bm4 = 16) to output the same. Otherwise (No), the process is advanced to the next step S1505 to check whether the replacement value C is 0.5 or not. If the replacement value C is 0.5 (Yes) the branch metric corresponding to the replacement value C =0.5 is derived from the branch metric table 230 (bm0 = 0.25, bm1 = 0.25, bm2 = 2.25, bm3 = 6.25, bm4 = 12.25) to output the same. Otherwise (No), the process is advanced to the next step S1510 to check whether the replacement value C is 1 or not. If the replacement value C is 1 (Yes) the branch metric corresponding to the replacement value C =1 is derived from the branch metric table 230 (bm0 = 1, bm1 = 0, bm2 = 1, bm3 = 4, bm4 = 9) to output the same. Otherwise (No), the process is advanced to the next step S1515 to check whether the replacement value C is 1.5 or not. If the replacement value C is 1.5 (Yes) the branch metric corresponding to the replacement value C =1.5 is derived from the branch metric table 230 (bm0 = 2.25, bm1 = 0.25, bm2 = 0.25, bm3 = 2.25, bm4 = 6.25) to output the same.

Furthermore, otherwise (No), the process is advanced to the next step S1520 to check whether the replacement value C is 2.0 or not. If the replacement value C is 2.0 (Yes) the branch metric corresponding to the replacement value C =2 is derived from the branch metric table 230 (bm0 = 4, bm1 = 1, bm2 = 0, bm3 = 1, bm4 = 4) to output the same. Otherwise (No), the process is advanced to the next step S1525 to check whether the replacement value C is 2.5 or not. If the replacement value C is 2.5 (Yes) the branch metric corresponding to the replacement value C =2.5 is derived from the branch metric table 230 (bm0 = 6.25, bm1 = 2.25, bm2 = 0.25, bm3 = 0.25, bm4 = 2.25) to output the same.

Otherwise (No), the process is advanced to the next step S1530 to check whether the replacement value C is 3 or not. If the replacement value C is 3 (Yes) the branch metric corresponding to the replacement value C = 3 is derived from the branch metric table 230 (bm0 = 9, bm1 = 4, bm2 = 1, bm3 = 0, bm4 = 1) to output the same. Otherwise (No), the process is advanced to the next step S1535 to check whether the replacement value C is 3.5 or not. If the replacement value C is 3.5 (Yes) the branch metric corresponding to the replacement value C = 3.5 is derived from the branch metric table 230 (bm0 = 12.25, bm1 = 6.25, bm2 = 2.25, bm3 = 0.25, bm4 = 0.25) to output the same (step S1535). Otherwise (No), since the replacement value C = 4, the branch metric corresponding to the replacement value C = 4 is derived from the branch metric table 230 (bm0 = 16, bm1 = 9, bm2 = 4, bm3 = 1, bm4 = 0) to output the same.

Thus, branch metric determining portion 22 obtain and output the branch metric which previously strages in the branch metric table 230 to the replacement value. The outputted branch metric is transmitted to ACS calculating device.

It should be noted that the values of the branch metric bm0 ~ bm4 to be preliminarily stored in the branch metric table 230 are values derived from operations "$bm0 = (C - B_0)^2 = (C - 0)^2$, $bm1 = (C - B_1)^2 = (C - 1)^2$, $bm2 = (C - B_2)^2 = (C - 2)^2$, $bm3 = (C - B_3)^2 = (C - 3)^2$, $bm4 = (C - B_4)^2 = (C - 4)^2$", even in the shown embodiment.

As discussed above, with the embodiment, by arranging the blind regions between the numerical value widths (zones), when the sampled value falls within the numerical value width, the replacement portion 210 replaces the sampled value with the expected value for the relevant numerical value width and when the sampled value falls within the blind region, the sampled value is replaced with the value determined for the relevant blind region. The branch metric determining portion 220 derives branch metric with reference to the storage content of the branch metric table 230. Therefore, it becomes possible to realize the branch metric operation device 200 or the Viterbi decoding device incorporating the same which can make the complicate operation unnecessary to reduce operation amount and permits down-sizing of the device.

Then, with taking the signal of PR (1, 2, 1) characteristics, as example, the operation conventionally required about 12 bits can be done about 7 bits. Furthermore, by providing the blind regions, it is effective to precisely calculate branch metric.

Next, discussion will be given for the process for replacing the sampled value with the predetermined expected value by providing numerical value width for the expected values and by providing the blind region between the expected values, assuming that the expected values are -16, -8, 0, 8, 16.

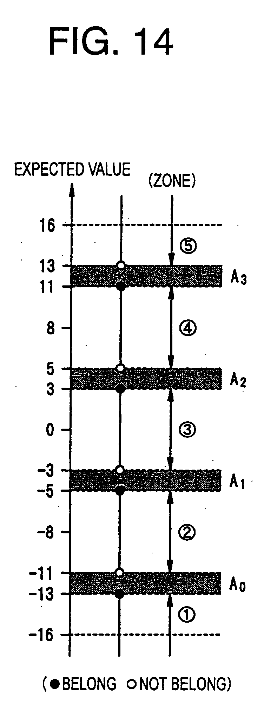

In this case, as shown in Fig. 14, zones $A_0$, $A_1$, $A_2$, $A_3$ where the samples values are "$13 \geqq S > 11$, $5 \geqq$

$S > 3$, $-3 \geqq S > -5$, $-11 \geqq S > -13$" are taken as blind zones and other regions ① to ⑤ are numerical value width corresponding to respective expected values.

As shown in Fig. 14, the positions of the blind regions are principally between respective expected values but are not necessary to arranged between all of the expected values, and the width thereof is not particularly limited.

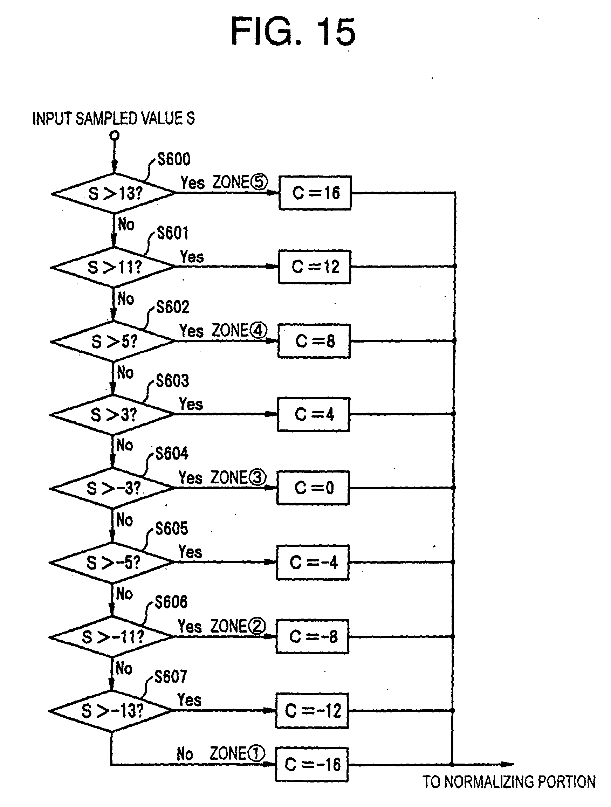

Next, process of the replacement portion 210 for replacing the sampled value with the predetermined value by providing the blind regions will be discussed with reference to Fig. 15.

At first, at step S600, check is performed whether the sampled value is greater than or equal to 13 or not. If the condition is met (Yes), judgment is made that the sampled value S belongs in the zone ⑤ to set the replacement value C = 16. Otherwise (No), the process is advanced to step S601. At step S601, check is performed whether the sampled value is greater than or equal to 11 or not. If the condition is met (Yes), judgment is made that the sampled value S belongs in the blind region $A_3$ to set the replacement value C = 12. Otherwise (No), the process is advanced to step S602.

At step S602, check is performed whether the sampled value is greater than or equal to 5 or not. If the condition is met (Yes), judgment is made that the sampled value S belongs in the zone ④ to set the replacement value C = 8. Otherwise (No), the process is advanced to step S603. At step S603, check is performed whether the sampled value is greater than or equal to 3 or not. If the condition is met (Yes), judgment is made that the sampled value S belongs in the blind region $A_2$ to set the replacement value C = 4. Otherwise (No), the process is advanced to step S604.

At step S604, check is performed whether the sampled value is greater than or equal to -3 or not. If the condition is met (Yes), judgment is made that the sampled value S belongs in the zone ③ to set the replacement value C = 0. Otherwise (No), the process is advanced to step S605. At step S605, check is performed whether the sampled value is greater than or equal to -5 or not. If the condition is met (Yes), judgment is made that the sampled value S belongs in the blind region $A_1$ to set the replacement value C = -4. Otherwise (No), the process is advanced to step S606.

At step S606, check is performed whether the sampled value is greater than or equal to -11 or not. If the condition is met (Yes), judgment is made that the sampled value S belongs in the zone ② to set the replacement value C = -8. Otherwise (No), the process is advanced to step S607. At step S607, check is performed whether the sampled value is greater than or equal to -13 or not. If the condition is met (Yes), judgment is made that the sampled value S belongs in the blind region $A_0$ to set the replacement value C = -12. Otherwise (No), judgment is made that the sampled value S belongs in the zone ① to set the replacement value C = -16.

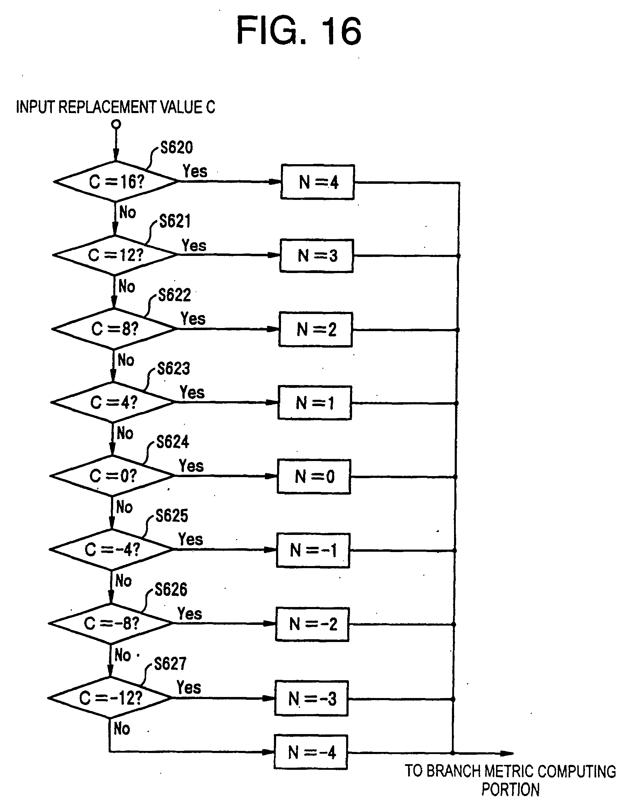

Next, the replaced value which is replaced as set forth above and the expected values are normalized to establish the simplest integer ratio by the normalizing portion 260. Discussion will be given for the normalizing process with reference to Fig. 16.

At first, at step S620, check is performed whether the replacement value is 16 or not. If the replacement value is 16, it is normalized to 4 (N = 4). Otherwise, the process is advanced to step S621 to check whether the replacement value is 12 or not. If the replacement value is 12, it is normalized to 3. Otherwise, the process is advanced to step S622. At step S622, check is performed whether the replacement value is 8 or not. If the replacement value is 8, it is normalized to 2. Otherwise, the process is advanced to step S623 to check whether the replacement value is 4 or not. If the replacement value is 4, it is normalized to 1.

At step S624, check is performed whether the replacement value is 0 or not. If the replacement value is 0, it is normalized to 0. Otherwise, the process is advanced to step S625 to check whether the replacement value is -4 or not. If the replacement value is -4, it is normalized to -1. Otherwise, the process is advanced to step S626. At step S626, check is performed whether the replacement value is -8 or not. If the replacement value is -8, it is normalized to -2. Otherwise, the process is advanced to step S627. At step S627, check is performed whether the replacement value is -12 or not. If the replacement value is -12, it is normalized to -4 and otherwise the replacement value is regarded as -16 to be normalized to -4.

By such normalizing process, the values after normalization becomes one of 4, 3, 2, 1, 0, -1, -2, -3, -4.

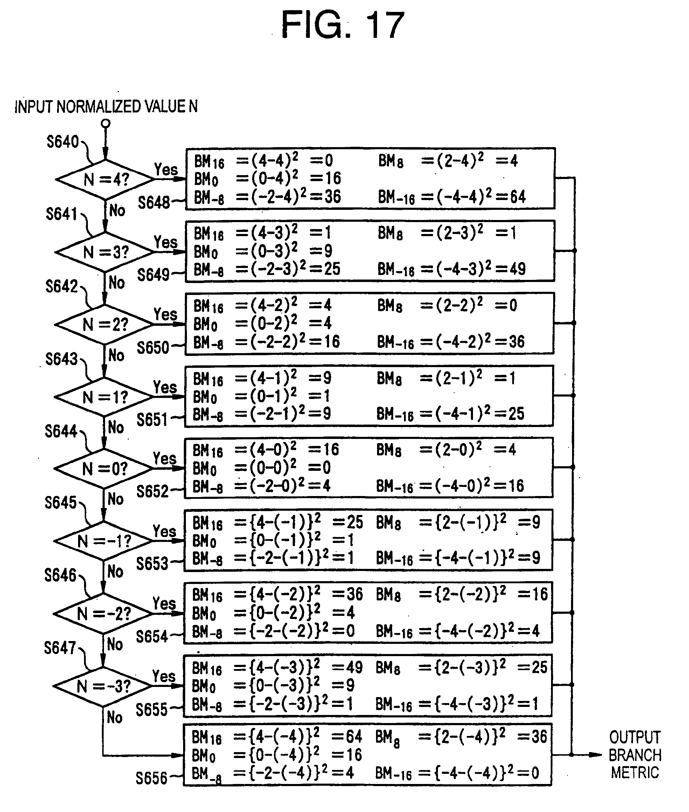

Next, on the basis of the normalized value derived by such normalizing process, the branch metric computing portion 280 derives the branch metric through the process as shown in Fig. 17. Discussion will be given therefor.

At first, at step S640, check is performed whether the normalized value N derived by the normalizing portion is 4 or not. If the normalized value is 4, process is advanced to step S648 to calculate five branch metrics $BM_{16}$, $BM_8$, $BM_0$, $BM_{-8}$, $BM_{-16}$ at Normalized value N being 4. Namely, $BM_{16} = (4 - 4)^2 = 0$, $BM_8 = (2 - 4)^2 = 4$, $BM_0 = (0 - 4)^2 = 16$, $BM_{-8} = (-2 - 4)^2 = 36$, $BM_{-16} = (-4 - 4)^2 = 64$.

Here, $BM_{16}$ is the branch metric for the expected value 16, $BM_8$ is the branch metric for the expected value 8, $BM_0$ is the branch metric for the expected value 0, $BM_{-8}$ is the branch metric for the expected value -8, and $BM_{-16}$ is the branch metric for the expected value -16.

Next, at step S640, if the normalized value N is not 4, the process is advanced to step S641. Then, check is performed whether the normalized value N is 3 or not. If the normalized value is 3, process is advanced to step S649 to calculate five branch metrics $BM_{16}$, $BM_8$, $BM_0$, $BM_{-8}$, $BM_{-16}$ at normalized value N being 3. Namely, $BM_{16} = (4 - 3)^2 = 1$, $BM_8 = (2 - 3)^2 = 1$, $BM_0 = (0 - 3)^2 = 9$, $BM_{-8} = (-2 - 3)^2 = 25$, $BM_{-16} = (-4 - 3)^2 = 49$.

Next, at step S641, if the normalized value N is not 3, the process is advanced to step S642. Then, check is performed whether the normalized value N is 2 or not. If the normalized value is 2, process is advanced to step S650 to calculate five branch metrics $BM_{16}$, $BM_8$, $BM_0$, $BM_{-8}$, $BM_{-16}$ at normalized value N being 2. Namely, $BM_{16} = (4 - 2)^2 = 4$, $BM_8 = (2 - 2)^2 = 0$, $BM_0 = (0 - 2)^2 = 4$, $BM_{-8} = (-2 - 2)^2 = 16$, $BM_{-16} = (-4 - 2)^2 = 36$.

Next, at step S642, if the normalized value N is not 2, the process is advanced to step S643. Then, check is performed whether the normalized value N is 1 or not. If the normalized value is 1, process is advanced to step S651 to calculate five branch metrics $BM_{16}$, $BM_8$, $BM_0$, $BM_{-8}$, $BM_{-16}$ at normalized value N being 1. Namely, $BM_{16} = (4 - 1)^2 = 9$, $BM_8 = (2 - 1)^2 = 1$, $BM_0 = (0 - 1)^2 = 1$, $BM_{-8} = (-2 - 1)^2 = 9$, $BM_{-16} = (-4 - 1)^2 = 25$.

Next, at step S643, if the normalized value N is not 1, the process is advanced to step S644. Then, check is performed whether the normalized value N is 0 or not. If the normalized value is 0, process is advanced to step S652 to calculate five branch metrics $BM_{16}$, $BM_8$, $BM_0$, $BM_{-8}$, $BM_{-16}$ at normalized value N being 0. Namely, $BM_{16} = (4 - 0)^2 = 16$, $BM_8 = (2 - 0)^2 = 4$, $BM_0 = (0 - 0)^2 = 0$, $BM_{-8} = (-2 - 0)^2 = 4$, $BM_{-16} = (-4 - 0)^2 = 16$.

Next, at step S644, if the normalized value N is not 0, the process is advanced to step S645. Then, check is performed whether the normalized value N is -1 or not. If the normalized value is -1, process is advanced to step S653 to calculate five branch metrics $BM_{16}$, $BM_8$, $BM_0$, $BM_{-8}$, $BM_{-16}$ at Normalized value N being -1. Namely, $BM_{16} = (4 - (-1))^2 = 25$, $BM_8 = (2 - (-1))^2 = 9$, $BM_0 = (0 - (-1))^2 = 1$, $BM_{-8} = (-2 - (-1))^2 = 1$, $BM_{-16} = (-4 - (-1))^2 = 9$.

Next, at step S645, if the normalized value N is not -1, the process is advanced to step S646. Then, check is performed whether the normalized value N is -2 or not. If the normalized value is -2, process is advanced to step S654 to calculate five branch metrics $BM_{16}$, $BM_8$, $BM_0$, $BM_{-8}$, $BM_{-16}$ at normalized value N being -2. Namely, $BM_{16} = (4 - (-2))^2 = 36$, $BM_8 = (2 - (-2))^2 = 16$, $BM_0 = (0 - (-2))^2 = 4$, $BM_{-8} = (-2 - (-2))^2 = 0$, $BM_{-16} = (-4 - (-2))^2 = 4$.

Next, at step S646, if the normalized value N is not -2, the process is advanced to step S647. Then, check is performed whether the normalized value N is -3 or not. If the normalized value is -3, process is advanced to step S655 to calculate five branch metrics $BM_{16}$, $BM_8$, $BM_0$, $BM_{-8}$, $BM_{-16}$ at normalized value N being -3. Namely, $BM_{16} = (4 - (-3))^2 = 49$, $BM_8 = (2 - (-3))^2 = 25$, $BM_0 = (0 - (-3))^2 = 9$, $BM_{-8} = (-2 - (-3))^2 = 1$, $BM_{-16} = (-4 - (-3))^2 = 1$.

Next, at step S647, if the normalized value N is not -3, the process is advanced to step S656 to regard the normalized value as -4, to calculate five branch metrics $BM_{16}$, $BM_8$, $BM_0$, $BM_{-8}$, $BM_{-16}$ at normalized value N being -4. Namely, $BM_{16} = (4 - (-4))^2 = 64$, $BM_8 = (2 - (-4))^2 = 36$, $BM_0 = (0 - (-4))^2 = 16$, $BM_{-8} = (-2 - (-4))^2 = 4$, $BM_{-16} = (-4 - (-4))^2 = 0$.

Since the branch metrics are derived as set forth above, in comparison with the case where branch metrics are derived in the case of Fig. 10, input bit width and the output bit width are increased to increase the scale of the circuit. However, the bit widths as required in the conventional system is not necessary. Furthermore, scale of the circuit can be made quite small using the combined logic in place of the multiplier.

It should be noted that while the maximum value of the foregoing branch metric is 64 (1000000 in binary number), by rounding this to 63 (111111 in binary number), the width of the branch metric can be reduced in 1 bit.

Next, discussion will be given for another embodiment of the branch metric operation device in accordance with the present invention with reference to Fig. 18.

In the branch metric operation device shown in Fig. 1 or Fig. 6, the expected values are preliminarily fixed as set forth above. On the other hand, in the actual system, it is possible to fluctuate the magnitude of the input signal due to error in setting of gain or other reason.

Then, another embodiment of the branch metric operation device adapts the expected value depending upon magnitude of fluctuation of the input signal for improving precision of the result of decoding of the Viterbi decoding device including the branch metric operation device.

The shown embodiment of the branch metric operation device according to the present invention includes the replacing portion 210, the normalizing portion 260, the normalizing portion 270, the branch metric computing portion 280, a sampled value storage portion 285, a judgment portion 290, and an expected value adapting portion 295.

The branch metric operation device is different from the branch metric operation device of Fig. 6 in the sample value storage portion 285, the judgment portion 290 and the expected value adapting portion 295. Therefore, the discussion will be given mainly for the construction of these different components.

The sampled value storage portion 285 is constructed with a memory which can be written and read freely, such as RAM, and is designed to sequentially store the input sampled value.

The judgment portion 290 makes judgment to which expected value corresponds to the sampled value stored in the sampled value storage portion 285 from the result of Viterbi decoding on the basis of branch metric output from the branch metric computing portion 280 to output the result of judgment to the expected value adapting portion 295.

The expected value adapting portion 295 outputs the adapted expected values to the normalizing portions 260 and 270 and the replacing portion 210 on the basis of the result of judgment of the judgment portion 290.

Next, operation of the branch metric operation device constructed as set forth above will be discussed.

Now, if the result of Viterbi decoding on the basis of the branch metric output from the branch metric computing portion 280 is assumed as "001110001100111100011101". In this case, the expected value is "-8, 8, 16, 8, -8, -16, -8, 8, 8, -8, -8, 8, 16, 16, 8, -8, -16, -8, 8, 16, 8, 0, 8".

On the other hand, the actual sampled value stored in the sampled value storage portion 285 is assumed as "-7, 9, 15, 10, -7, -14, -7, 8, 10, -7, -7, 9, 15, 18, 10, -7, -14, -7, 7, 12, 7, 1, 6", due to superimposed noise, for example.

In the judgment portion 290, judgment is made by the result of Viterbi decoding to which of the expected values, the sampled value stored in the sampled value storage portion 285 is corresponded. In the shown example, the sampled values -7 are all corresponded to the expected value -8.

At this time, the expected value adapting portion 295 generates adapted new expected value from the conventional expected value and the sampled value corresponded thereto. For example, an average of the corresponded sampled value, or moving average is taken as new expected value. In addition, it can be considered a method to modify as:

new expected value = old expected value $\times$ (1 - $\alpha$)

+ corresponded sampled value $\times$ $\alpha$

Here, $\alpha$ is a value establishing a relationship of $0 \leqq \alpha < 1$. The adapted expected values are output to the replacing portion 210 and the normalizing portions 260 and 270.

In the replacing portion 210, the numerical value width is set depending upon the preliminarily set plurality of expected values. Therefore, when the expected values are modified by adapting, the numerical value width is modified corresponding thereto. For example, when the preliminarily set expected values are initially 16, 8, 0, -8, -16, the numerical value width is divided into $S > 12$, $12 \geqq S > 4$, $4 \geqq S > -4$, $-4 \geqq S > -12$, $-12 \geqq S$ (see Fig. 7). However, when the adapted expected values are 10, 5, 9, -5, -10, the numerical value widths are modified as $S > 7$, $7 \geqq S > 2$, $2 \geqq S > -3$, $-3 \geqq S > -8$, $-8 \geqq S$ to adapt the numerical value widths in association with the adapted expected values. The values after replacing in the replacing portion 210 are 10, 5, 0, -5, -10 with respect to the numerical value widths, respectively.

At the same time, in the normalizing portions 260 and 270, initially, normalization is performed to make 16 into 2, 8 into 1, 0 into 0, -8 into -1 and -16 into -2 (see Fig. 9). Associating with adapting of the expected value, normalization is performed to make 10 into 2, 5 into 1, 0 into 0, -5 into -1 and -10 into -2.

On the other hand, with setting the expected values as -16, -8, 0, 8, 16, the numerical value widths for each of these expected values are provided. In conjunction therewith, when the blind regions are provided between the expected values, the blind regions are set in the regions $13 \geqq S \geqq 11$, $5 \geqq S > 3$, $-3 \geqq S > -5$, $-11 \geqq S > -13$ (see Fig. 14). However, similarly to the above, when the expected values becomes 10, 5, 0, -5, -10, the blind regions are adapted to be $8 \geqq S > 7$, $3 \geqq S > 2$, $-2 \geqq S > -3$, $-7 \geqq S > -8$. The value after replacement is set to be 10, 8, 5, 3, 0, -3, -5, -8, -10/

Similarly, in the normalizing portion, initially, normalization is performed to make 16 into 4, 12 into 3, 8 into 2, 4 into 1, 0 into 0, -4 into -1, -8 into -2, -12 into -3 and -16 into -4. Associating with adapting of the expected value, normalization is performed to make 10 into 4, 8 into 3, 5 into 2, 3 into 1, 0 into 0, -3 into -1, -5 into -2, -8 into -3 and -10 into -2.

As discussed above, in the other embodiment of the branch metric operation device, since the expected values are adapted depending upon fluctuation of magnitude of the input signal, the Viterbi decoding device including the branch metric operation device can enhance precision of the result of decoding.

It should be noted that the present invention can be wholly realized by hardware by integrating into an LSI, it is of course possible to realize the device by storing at least a part thereof in a storage medium, such as ROM and executing the process by CPU according to an operation procedure.

On the other hand, the present invention is suitable for application in signal reproduction process from a storage medium, such as CD, DVD, MO or the like recording digital audio signal or video signal. However, needless to say, it is also applicable for a reproduction system of digital signal in other any fields, such as demodulating portion of a cellular telephone or the like.

INDUSTRIAL APPLICABILITY

As set forth above, with the branch metric operation device according to the present invention, complicate operation in deriving branch metric is unnecessary to reduce operation amount to reduce size of the device.

On the other hand, in the branch metric operation device according to the present invention, the expected values are adapted to fluctuation of magnitude of the input signal. Therefore, in this case, the foregoing effect can be obtained, Furthermore, precision of the result of Viterbi decoding can be enhanced.

On the other hand, according to the Viterbi decoding device of the present invention, the Viterbi decoding device can be instructed with incorporating the branch metric operation device, scale of the Viterbi decoding device can be also made small.

**Claims**

1. A branch metric operation device for operation of branch metric to be used for decoding in a Viterbi algorithm on the basis of a sampled value of an input data and a preliminarily set plurality of expected values, comprising:

   replacing means for replacing said sampled value with one of said expected values according to a predetermined rule;
   storage means for storing branch metrics preliminarily derived on the basis of said replaced sampled value and said plurality of expected values with correspondence to said replaced sampled value; and
   branch metric determining means for deriving branch metrics corresponding to said replaced sampled value from said storage means.

2. A branch metric operation device for operation of branch metric to be used for decoding in a Viterbi algorithm on the basis of a sampled value of an input data and a preliminarily set plurality of expected values, comprising:

   replacing means for replacing said sampled value with one of said expected values according to a predetermined rule;
   normalizing means for normalizing said replaced sampled value and said expected values; and
   branch metric calculating means for deriving branch metrics from said normalized sampled value and said normalized plurality of expected values.

3. A branch metric operation device as set forth in claim 1 or 2, wherein when said sampled value is present within said numerical value width determined for each expected value, said predetermined rule is to replace said sampled value with the expected value for a relevant numerical value width,
   said replacing means is means for replacing said sampled value with the expected value for said relevant numerical value width when said sampled value is present within the numerical value width determined with respect to each expected value.

4. A branch metric operation device for operation of branch metric to be used for decoding in a Viterbi algorithm on the basis of a sampled value of an input data and a preliminarily set plurality of expected values, comprising:

replacing means for determining numerical value width for each expected value and arranging blind regions between determined numerical value widths, when said sampled value is present in a certain numerical value width, replacing said sampled value with the expected value for the relevant numerical value width, and when said sampled value is present in certain blind region, replacing said sampled value with a value determined for the relevant blind region;

storage means for storing branch metrics preliminarily derived on the basis of said replaced sampled value and said plurality of expected values with correspondence to said replaced sampled value; and

branch metric determining means for deriving branch metrics corresponding to said replaced sampled value from said storage means.

5. A branch metric operation device for operation of branch metric to be used for decoding in a Viterbi algorithm on the basis of a sampled value of an input data and a preliminarily set plurality of expected values, comprising:

replacing means for determining numerical value width for each expected value and arranging blind regions between determined numerical value widths, when said sampled value is present in a certain numerical value width, replacing said sampled value with the expected value for the relevant numerical value width, and when said sampled value is present in certain blind region, replacing said sampled value with a value determined for the relevant blind region;

normalizing means for normalizing said replaced sampled value and said expected values; and

branch metric calculating means for deriving branch metrics from said normalized sampled value and said normalized plurality of expected values.

6. A branch metric operation device as set forth in claim 2, 3 or 5, which further comprises

storage means for storing said sampled value; judgment means for making judgment which of said expected values corresponds to the sampled value stored in said storage means from a result of Viterbi decoding on the basis of result of operation of said branch metric operation means; and

adapting means for adapting said expected values on the basis of the result of judgment, said replacing means is adapted to perform replacement on the basis of said adapted expected value, and said normalizing means performs normalization on the basis of said adapted expected values.

7. A Viterbi decoding device comprising:

a branch metric operation device defined in any one of claims 1 to 6; an ACS computing device calculating a path metric corresponding to each state; a path memory storing information showing a probably path trace per each state; and decoding means performing data decoding determining a surviving path with reference to information stored in said path memory.

# FIG. 1

EXPECTED VALUE (B0,B1,B2,B3,B4)

**200**

BRANCH METRIC
OPERATION DEVICE

**30**

ACS COMPUTING
DEVICE

**10**

**210**

REPLACING
PORTION

ANALOG
WAVEFORM

A/D
CONVERTER

**220**

BRANCH METRIC
DETERMINING PORTION

**40**

PATH MEMORY

**230**

**50**

BRANCH METRIC
TABLE

DECODER

DIGITAL DATA

# FIG. 2

EXPECTED VALUE

(● BELONG  ○ NOT BELONG)

# FIG. 3

INPUT SAMPLED VALUE S

TO PROCESS-MAKING
REFERENCE TO BRANCH METRIC
TABLE

# FIG. 4

C INPUT

**230** BRANCH METRIC TABLE

S400

C = 0? — Yes ① — bm0 = 0, bm1 = 1, bm2 = 4
bm3 = 9, bm4 = 16

No

S405

C = 1? — Yes ② — bm0 = 1, bm1 = 0, bm2 = 1
bm3 = 4, bm4 = 9

No

S410

C = 2? — Yes ③ — bm0 = 4, bm1 = 1, bm2 = 0
bm3 = 1, bm4 = 4

No

S415

C = 3? — Yes ④ — bm0 = 9, bm1 = 4, bm2 = 1
bm3 = 0, bm4 = 1

No
(C = 4) ⑤ — bm0 = 16, bm1 = 9, bm2 = 4
bm3 = 1, bm4 = 0

TO ACS COMPUTING DEVICE

# FIG. 5 (a)

```
┌─────────────────┐          ┌──────────────┐        EXPECTED VALUE
│ A/D CONVERSION  │─────────▶│ SUBTRACTION  │◀────    (−32~+31)
└─────────────────┘          └──────────────┘         6 BITS
    (−32~+31)                      │
     6 BITS                        │        (−63~+63)
                                   ▼          7 BITS
                            ┌──────────────┐
                            │  ABSOLUTE    │
                            │   VALUE      │
                            └──────────────┘
                                   │        (0~+63)
                                   ▼         6 BITS
                            ┌──────────────┐
                            │   SQUARE     │
                            └──────────────┘

                                           (0~+3969)
                                            12 BITS
```

# FIG. 5 (b)

```
┌─────────────────┐          ┌──────────────┐        EXPECTED VALUE
│ A/D CONVERSION  │─────────▶│ REPLACEMENT  │◀────    (−32~+31)
└─────────────────┘          └──────────────┘         6 BITS
    (−32~+31)                   (0, 1, 2, 3, 4)
     6 BITS                        3 BITS
                                   │
                                   │
                                   ▼
              ┌───────────────────────────────────────────┐
              │  MAKE REFERENCE TO BRANCH METRIC TABLE     │
              └───────────────────────────────────────────┘

                                (0~16)
                                5 BITS
```

# FIG. 6

EXPECTED VALUE

SAMPLING VALUE

REPLACING PORTION — 210

NORMALIZING PORTION — 270

NORMALIZING PORTION — 260

BRANCH METRIC COMPUTING PORTION — 280

TO ACS COMPUTING DEVICE

# FIG. 7

EXPECTED VALUE

(ZONE)

16

12 — ⑤

8 — ④

4

0 — ③

-4

-8 — ②

-12

-16 — ①

(● BELONG ○ NOT BELONG)

# FIG. 8

INPUT SAMPLED VALUE S

S500 — S $\leqq$ -12? — Yes ZONE① → C = -16 → (to normalizing line)

No ↓

S501 — S $\leqq$ -4? — Yes ZONE② → C = -8

No ↓

S502 — S $\leqq$ 4? — Yes ZONE③ → C = 0

No ↓

S503 — S $\leqq$ 12? — Yes ZONE④ → C = 8

No ↓

C = 16

TO NORMALIZING PORTION

# FIG. 9

INPUT REPLACEMENT VALUE C

S511 — C = 16? — Yes → N = 2

No ↓

S512 — C = 8? — Yes → N = 1

No ↓

S513 — C = 0? — Yes → N = 0

No ↓

S514 — C = -8? — Yes → N = -1

No ↓

N = -2

TO BRANCH METRIC COMPUTING PORTION

21

# FIG. 10

INPUT NORMALIZED VALUE N

S530

$N = 2?$ —— Yes ——→

$$
\begin{aligned}
BM_{16} &= (2-2)^2 &= 0 \\
BM_8 &= (1-2)^2 &= 1 \\
BM_0 &= (0-2)^2 &= 4 \\
BM_{-8} &= (-1-2)^2 &= 9 \\
BM_{-16} &= (-2-2)^2 &= 16
\end{aligned}
$$

S534

No

S531

$N = 1?$ —— Yes ——→

$$
\begin{aligned}
BM_{16} &= (2-1)^2 &= 1 \\
BM_8 &= (1-1)^2 &= 0 \\
BM_0 &= (0-1)^2 &= 1 \\
BM_{-8} &= (-1-1)^2 &= 4 \\
BM_{-16} &= (-2-1)^2 &= 9
\end{aligned}
$$

S535

No

S532

$N = 0?$ —— Yes ——→

$$
\begin{aligned}
BM_{16} &= (2-0)^2 &= 4 \\
BM_8 &= (1-0)^2 &= 1 \\
BM_0 &= (0-0)^2 &= 0 \\
BM_{-8} &= (-1-0)^2 &= 1 \\
BM_{-16} &= (-2-0)^2 &= 4
\end{aligned}
$$

S536

No

S533

$N = -1?$ —— Yes ——→

$$
\begin{aligned}
BM_{16} &= \{2-(-1)\}^2 &= 9 \\
BM_8 &= \{1-(-1)\}^2 &= 4 \\
BM_0 &= \{0-(-1)\}^2 &= 1 \\
BM_{-8} &= \{-1-(-1)\}^2 &= 0 \\
BM_{-16} &= \{-2-(-1)\}^2 &= 1
\end{aligned}
$$

S537

No

$$
\begin{aligned}
BM_{16} &= \{2-(-2)\}^2 &= 16 \\
BM_8 &= \{1-(-2)\}^2 &= 9 \\
BM_0 &= \{0-(-2)\}^2 &= 4 \\
BM_{-8} &= \{-1-(-2)\}^2 &= 1 \\
BM_{-16} &= \{-2-(-2)\}^2 &= 0
\end{aligned}
$$

S538

OUTPUT BRANCH METRIC

EP 1 120 916 A1

# FIG. 11

EXPECTED VALUE

(● BELONG  ○ NOT BELONG)

# FIG. 12

INPUT SAMPLED VALUE S

S1400

$S \leq 0.4?$ — Yes → $C = 0$ ①

No — S1405

$0.4 < S \leq 0.6?$ — Yes → $C = 0.5$ A0

No — S1410

$0.6 < S \leq 1.4?$ — Yes → $C = 1$ ②

No — S1415

$1.4 < S \leq 1.6?$ — Yes → $C = 1.5$ A1

No — S1420

$1.6 < S \leq 2.4?$ — Yes → $C = 2$ ③

No — S1425

$2.4 < S \leq 2.6?$ — Yes → $C = 2.5$ A2

No — S1430

$2.6 < S \leq 3.4?$ — Yes → $C = 3$ ④

No — S1435

$3.4 < S \leq 3.6?$ — Yes → $C = 3.5$ A3

No

$C = 4$ ⑤

TO PROCESS MAKING
REFERENCE TO BRANCH METRIC
TABLE

# FIG. 13

INPUT C

230 BRANCH METRIC TABLE

S1500

C = 0? — Yes → bm0 = 0, bm1 = 1, bm2 = 4  bm3 = 9, bm4 = 16

No

S1505

C = 0.5? — Yes → bm0 = 0.25, bm1 = 0.25,  bm2 = 2.25  bm3 = 6.25, bm4 = 12.25

No

S1510

C = 1? — Yes → bm0 = 1, bm1 = 0, bm2 = 1  bm3 = 4, bm4 = 9

No

S1515

C = 1.5? — Yes → bm0 = 2.25, bm1 = 0.25,  bm2 = 0.25  bm3 = 2.25, bm4 = 6.25

No

S1520

C = 2? — Yes → bm0 = 4, bm1 = 1, bm2 = 0  bm3 = 1, bm4 = 4

No

S1525

C = 2.5? — Yes → bm0 = 6.25, bm1 = 2.25,  bm2 = 0.25  bm3 = 0.25, bm4 = 2.25

No

S1530

C = 3? — Yes → bm0 = 9, bm1 = 4, bm2 = 1  bm3 = 0, bm4 = 1

No

S1535

C = 3.5? — Yes → bm0 = 12.25, bm1 =  6.25, bm2 = 2.25,  bm3 = 0.25, bm4 = 0.25

No

C = 4 → bm0 = 16, bm1 = 9, bm2 = 4  bm3 = 1, bm4 = 0

ACS COMPUTING DEVICE

# FIG. 14

(●BELONG  ○NOT BELONG)

# FIG. 15

INPUT SAMPLED VALUE S

```
                    S600
              Yes  ZONE⑤
S > 13?  ──────────────────  C = 16
   │ No
   │       S601
   │       Yes
S > 11?  ──────────────────  C = 12
   │ No
   │       S602
   │      Yes  ZONE④
S > 5?  ───────────────────  C = 8
   │ No
   │       S603
   │       Yes
S > 3?  ───────────────────  C = 4
   │ No
   │       S604
   │      Yes  ZONE③
S > -3?  ──────────────────  C = 0
   │ No
   │       S605
   │       Yes
S > -5?  ──────────────────  C = -4
   │ No
   │       S606
   │      Yes  ZONE②
S > -11?  ─────────────────  C = -8
   │ No
   │       S607
   │       Yes
S > -13?  ─────────────────  C = -12
   │
   │ No  ZONE①
   └──────────────────────  C = -16  ──────►  TO NORMALIZING PORTION
```

# FIG. 16

INPUT REPLACEMENT VALUE C

S620
C = 16?  — Yes → N = 4

No

S621
C = 12?  — Yes → N = 3

No

S622
C = 8?  — Yes → N = 2

No

S623
C = 4?  — Yes → N = 1

No

S624
C = 0?  — Yes → N = 0

No

S625
C = -4?  — Yes → N = -1

No

S626
C = -8?  — Yes → N = -2

No

S627
C = -12?  — Yes → N = -3

No

N = -4

TO BRANCH METRIC COMPUTING
PORTION

# FIG. 17

INPUT NORMALIZED VALUE N

S640 — N = 4? — Yes →

S648 —
$BM_{16} = (4-4)^2 = 0$  $BM_8 = (2-4)^2 = 4$
$BM_0 = (0-4)^2 = 16$
$BM_{-8} = (-2-4)^2 = 36$  $BM_{-16} = (-4-4)^2 = 64$

No

S641 — N = 3? — Yes →

S649 —
$BM_{16} = (4-3)^2 = 1$  $BM_8 = (2-3)^2 = 1$
$BM_0 = (0-3)^2 = 9$
$BM_{-8} = (-2-3)^2 = 25$  $BM_{-16} = (-4-3)^2 = 49$

No

S642 — N = 2? — Yes →

S650 —
$BM_{16} = (4-2)^2 = 4$  $BM_8 = (2-2)^2 = 0$
$BM_0 = (0-2)^2 = 4$
$BM_{-8} = (-2-2)^2 = 16$  $BM_{-16} = (-4-2)^2 = 36$

No

S643 — N = 1? — Yes →

S651 —
$BM_{16} = (4-1)^2 = 9$  $BM_8 = (2-1)^2 = 1$
$BM_0 = (0-1)^2 = 1$
$BM_{-8} = (-2-1)^2 = 9$  $BM_{-16} = (-4-1)^2 = 25$

No

S644 — N = 0? — Yes →

S652 —
$BM_{16} = (4-0)^2 = 16$  $BM_8 = (2-0)^2 = 4$
$BM_0 = (0-0)^2 = 0$
$BM_{-8} = (-2-0)^2 = 4$  $BM_{-16} = (-4-0)^2 = 16$

No

S645 — N = -1? — Yes →

S653 —
$BM_{16} = \{4-(-1)\}^2 = 25$  $BM_8 = \{2-(-1)\}^2 = 9$
$BM_0 = \{0-(-1)\}^2 = 1$
$BM_{-8} = \{-2-(-1)\}^2 = 1$  $BM_{-16} = \{-4-(-1)\}^2 = 9$

No

S646 — N = -2? — Yes →

S654 —
$BM_{16} = \{4-(-2)\}^2 = 36$  $BM_8 = \{2-(-2)\}^2 = 16$
$BM_0 = \{0-(-2)\}^2 = 4$
$BM_{-8} = \{-2-(-2)\}^2 = 0$  $BM_{-16} = \{-4-(-2)\}^2 = 4$

No

S647 — N = -3? — Yes →

S655 —
$BM_{16} = \{4-(-3)\}^2 = 49$  $BM_8 = \{2-(-3)\}^2 = 25$
$BM_0 = \{0-(-3)\}^2 = 9$
$BM_{-8} = \{-2-(-3)\}^2 = 1$  $BM_{-16} = \{-4-(-3)\}^2 = 1$

No

S656 —
$BM_{16} = \{4-(-4)\}^2 = 64$  $BM_8 = \{2-(-4)\}^2 = 36$
$BM_0 = \{0-(-4)\}^2 = 16$
$BM_{-8} = \{-2-(-4)\}^2 = 4$  $BM_{-16} = \{-4-(-4)\}^2 = 0$

OUTPUT BRANCH METRIC

# FIG. 18

295

EXPECTED VALUE
ADAPTING PORTION

210

SAMPLING VALUE

REPLACING
PORTION

SAMPLED VALUE
STORAGE PORTION

270

285

260

NORMALIZING
PORTION

NORMALIZING
PORTION

290

JUDGMENT
PORTION

NORMALIZING
PORTION

280

BRANCH METRIC
COMPUTING
PORTION

VITERBI DECODING

TO ACS COMPUTING DEVICE

# FIG. 19

| | | |
|---|---|---|
| ORIGINAL DATA STRING × 1 | 0 0 1 1 1 0 0 0 1 1 0 0 1 1 1 1 0 0 0 1 1 1 0 1 1 | |
| T DELAYED DATA STRING × 2 | 0 0 2 2 2 0 0 0 2 2 0 0 2 2 2 2 0 0 0 2 2 2 0 2 | |
| 2T DELAYED DATA STRING × 1 | 0 0 1 1 1 0 0 0 1 1 0 0 1 1 1 1 0 0 0 1 1 1 0 | |
| EXPECTED VALUE STRING | 1 3 4 3 1 0 1 3 3 1 1 3 4 4 3 1 0 1 3 4 3 2 3 | |

# FIG. 20

# FIG. 21

# FIG. 22

EXPECTED VALUE $(B_0, B_1, B_2, B_3, B_4)$

ANALOG WAVEFORM → [ A/D CONVERTER ] **10** →

**20** BRANCH METRIC OPERATION DEVICE

**21** SUBTRACTING PORTION

**22** ABSOLUTE VALUE OPERATING PORTION

**23** SQUARE OPERATING PORTION

**30** ACS COMPUTING DEVICE

**40** PATH MEMORY

**50** DECODER

→ DIGITAL DATA

# FIG. 23

**30** ACS COMPUTING DEVICE

(BRANCH METRIC)

Pm00

bm0 — 31a — COMPA-RATOR — 33a — PATH MEMORY (M00)

bm1 — 32a — 34a — M U X — PATH METRIC REGISTER (Pm00) — 35a

Pm10 — ACS00 UNIT

Pm00

bm1 — 31b — COMPA-RATOR — 33b — PATH MEMORY (M01)

bm2 — 32b — 34b — M U X — PATH METRIC REGISTER (Pm01) — 35b

Pm10 — ACS01 UNIT

Pm01

bm2 — 31c — COMPA-RATOR — 33c — PATH MEMORY (M10)

bm3 — 32c — 34c — M U X — PATH METRIC REGISTER (Pm10) — 35c

Pm11 — ACS10 UNIT

Pm01

bm3 — 31d — COMPA-RATOR — 33d — PATH MEMORY (M11)

bm4 — 32d — 34d — M U X — PATH METRIC REGISTER (Pm11) — 35d

Pm11 — ACS11 UNIT

# FIG. 24

SAMPLED VALUE S

| | | | | |
|---|---|---|---|---|
| B0 → SUB-TRACTION | B1 → SUB-TRACTION | B2 → SUB-TRACTION | B3 → SUB-TRACTION | B4 → SUB-TRACTION |
| ABSOLUTE VALUE | ABSOLUTE VALUE | ABSOLUTE VALUE | ABSOLUTE VALUE | ABSOLUTE VALUE |
| 2 SQUARE | 2 SQUARE | 2 SQUARE | 2 SQUARE | 2 SQUARE |
| bm0 | bm1 | bm2 | bm3 | bm4 |

TO ACS COMPUTING DEVICE

# FIG. 25

M00   1      0      0      1      1

# FIG. 26

PATH METRIC
MINIMUM

S01 ← S11 ← S11 ← S10 ← S00 ← S01 ← S11

(DECODED DATA)   1     1     0     0     1     1

# FIG. 27

EXPECTED VALUE
+16, +8, 0, −8, −16

SAMPLED VALUE
+14

BRANCH METRIC OUTPUT

$\{+16-(+14)\}^2 = 2^2 = 4$

$\{+8-(+14)\}^2 = (-6)^2 = 36$

$\{0-(+14)\}^2 = (-14)^2 = 196$

$\{-8-(+14)\}^2 = (-22)^2 = 484$

$\{-16-(+14)\}^2 = (-30)^2 = 900$

BRANCH METRIC OUTPUT

**INTERNATIONAL SEARCH REPORT**

| International application No. |
|---|
| PCT/JP99/05086 |

---

A.  CLASSIFICATION OF SUBJECT MATTER
    Int.Cl$^7$   H03M 13/41

According to International Patent Classification (IPC) or to both national classification and IPC

B.   FIELDS SEARCHED

Minimum documentation searched (classification system followed by classification symbols)
    Int.Cl$^7$   H03M 13/41

Documentation searched other than minimum documentation to the extent that such documents are included in the fields searched
    Jitsuyo Shinan Koho          1926-1996      Toroku Jitsuyo Shinan Koho  1994-1999
    Kokai Jitsuyo Shinan Koho    1971-1999      Jitsuyo Shinan Toroku Koho  1996-1999

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| X | L.Richard Carley and Srinath Sridharan "A pipelined 16-State Generalized Viterbi Decoder", IEEE Transactions on Magnetics, Vol. 34, No. 1, January (1998), P.181-186, | 1,3,4,7 |
| Y | Fig.2 | 2,5,6 |
| Y | JP, 08-037466, A (Sharp Corporation), 06 February, 1996 (06.02.96), Fig. 11   (Family: none) | 2,5,6 |
| Y | JP, 61-135234, A (NEC Corporation), 23 June, 1986 (23.06.86), Claims; Fig. 1   (Family: none) | 6 |
| A | JP, 11-031978, A (Sony Corporation), 02 February, 1999 (02.02.99), Figs. 1, 2   (Family: none) | 1-7 |

☐ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 22 December, 1999 (22.12.99) | 28 December, 1999 (28.12.99) |

| Name and mailing address of the ISA/ | Authorized officer |
|---|---|
| Japanese Patent Office | |
| Facsimile No. | Telephone No. |

Form PCT/ISA/210 (second sheet) (July 1992)